# EUROPEAN PATENT SPECIFICATION

(11) **EP 4 255 158 B1**
(45) Date of publication and mention of the grant of the patent: **19.03.2025**
(21) Application number: 23160335.8
(22) Date of filing: 07.03.2023
(51) Int. Cl.: H10N 30/076, B06B 1/06, H10N 30/00, H10N 30/853, H10N 30/87

(54) **PIEZOELECTRIC FILM INTEGRATED DEVICE, MANUFACTURING METHOD THEREOF, AND ACOUSTIC OSCILLATION SENSOR**
INTEGRIERTE PIEZOELEKTRISCHE DÜNNSCHICHTVORRICHTUNG, HERSTELLUNGSVERFAHREN DAFÜR UND AKUSTISCHER OSZILLATIONSSENSOR
DISPOSITIF INTÉGRÉ À FILM PIÉZOÉLECTRIQUE, SON PROCÉDÉ DE FABRICATION ET CAPTEUR D'OSCILLATION ACOUSTIQUE

(30) Priority: 30.03.2022 JP 2022055955
(43) Date of publication of application: 04.10.2023
(73) Proprietor: Oki Electric Industry Co., Ltd., Minato-ku Tokyo 105-8460 (JP); I-PEX Piezo Solutions Inc., Ube-shi, Yamaguchi 755-0152 (JP)
(72) Inventor: FURUTA, Hironori, Tokyo 105-8460 (JP); KOSAKA, Toru, Tokyo 105-8460 (JP); SUZUKI, Takahito, Tokyo 105-8460 (JP); TANIGAWA, Kenichi, Tokyo 105-8460 (JP); ISHIKAWA, Takuma, Tokyo 105-8460 (JP); KITAJIMA, Yutaka, Tokyo 105-8460 (JP); KONISHI, Akio, Ube-shi 755-0152 (JP); KANAMORI, Hiroaki, Ube-shi 755-0152 (JP); IIZUKA, Takeshi, Ube-shi 755-0152 (JP)
(74) Representative: Betten & Resch

(56) References cited:
- CN-A- 113 574 690
- JP-A- 2021 166 220
- US-A1- 2020 055 088
- LI L ET AL: "Piezoelectric AlGaAs bimorph microactuators", JOURNAL OF MICROMECHANICS AND MICROENGINEERING, INSTITUTE OF PHYSICS PUBLISHING, BRISTOL, GB, vol. 16, no. 5, 1 May 2006 (2006-05-01), pages 1062 - 1066, XP020105003, ISSN: 0960-1317, DOI: 10.1088/0960-1317/16/5/026

## Description

### BACKGROUND OF THE INVENTION

### 1. Field of the Invention

The present disclosure relates to a piezoelectric film integrated device, a manufacturing method thereof, and an acoustic oscillation sensor.

### 2. Description of the Related Art

Conventionally, there has been disclosed a piezoelectric element in which two piezoelectric films are stacked together via an adhesion layer. See Japanese Patent Application Publication No. 2017-130701 (Patent Reference 1), for example.

However, a high-performance piezoelectric film integrated device cannot be obtained when a plurality of piezoelectric films are arranged in superimposition in a conventional device.

The document from LI L ET AL: "Piezoelectric AlGaAs bimorph microactuators", JOURNAL OF MICROMECHANICS AND MICROENGINEERING, INSTITUTE OF PHYSICS PUBLISHING, BRISTOL, GB, vol. 16, no. 5, 1 May 2006 (2006-05-01), pages 1062-1066, XP020105003, ISSN: 0960-1317, DOI: 10.1088/0960-1317/16/5/026 discloses piezoelectric bimorph cantilever microactuators based on single-crystal A1_{0.3}Ga_{0.7}As. Fabricated devices are characterized for their quasistatic and resonant behavior when driven in both unimorph and bimorph configurations. Quasistatic actuator behavior is compared with a simple analytic model. Measured unimorph and bimorph tip deflections match well with the model, with deviations resulting from imperfections in device geometry and electrical resistivity of the electrodes. The•effects of bimorph actuation on linearity and structural damping at resonance are also evaluated.

As further prior art, reference is made to CN 113 574 690 A and to US 2020/055088 Al.

### SUMMARY OF THE INVENTION

An object of the present disclosure is to provide a high-performance piezoelectric film integrated device in which two or more types of piezoelectric elements each including a monocrystalline piezoelectric film are provided in superimposition, a manufacturing method thereof, and an acoustic oscillation sensor including the piezoelectric film integrated device.

A piezoelectric film integrated device according to the present invention is defined in claim 1. Dependent claims define advantageous embodiments.

According to the present disclosure, by providing two or more types of piezoelectric elements each including a monocrystalline piezoelectric film in superimposition, the performance of the piezoelectric film integrated device and the acoustic oscillation sensor can be increased.

### BRIEF DESCRIPTION OF THE DRAWINGS

The present disclosure will become more fully understood from the detailed description given hereinbelow and the accompanying drawings which are given by way of illustration only, and wherein:
Fig. 1 is a side view schematically showing the structure of a piezoelectric film integrated device according to a first embodiment;
Fig. 2 is a top view schematically showing the structure of the piezoelectric film integrated device in Fig. 1;
Fig. 3 is a cross-sectional view of the piezoelectric film integrated device in Fig. 2 taken along the line S3-S3;
Fig. 4 is a bottom view schematically showing the structure of the piezoelectric film integrated device in Fig. 1;
Fig. 5 is a cross-sectional view schematically showing the structure of an epitaxial growth film including a monocrystalline PZT film as a monocrystalline piezoelectric film;
Fig. 6 is a diagram showing the crystal structure of the monocrystalline PZT film in Fig. 5;
Fig. 7 is a diagram schematically showing the crystal structure of the epitaxial growth film in Fig. 5;
Fig. 8 is a cross-sectional view schematically showing the structure of the epitaxial growth film including a monocrystalline AlN film as a monocrystalline piezoelectric film;
Fig. 9A is a diagram schematically showing a (111)-surface of a crystal of each of a monocrystalline SRO film, monocrystalline Pt and monocrystalline ZrO₂ in Fig. 8, and Fig. 9B is a diagram showing a lattice constant of the crystal of monocrystalline SRO;
Fig. 10A is a diagram schematically showing the crystal structure of the monocrystalline AlN film in Fig. 8, and Fig. 10B is a diagram showing the lattice constant of the crystal of monocrystalline AlN;
Fig. 11 is a flowchart showing a method of manufacturing the piezoelectric film integrated device in Fig. 1;
Figs. 12A and 12B are a cross-sectional view and a top view schematically showing the structure of an electrode in step ST102 in Fig. 11;
Figs. 13A and 13B are a top view and a cross-sectional view schematically showing the structure of a first epitaxial growth film in step ST103 in Fig. 11;
Figs. 14A and 14B are a top view and a cross-sectional view schematically showing the structure of the first epitaxial growth film in step ST104 in Fig. 11;
Fig. 15 is a cross-sectional view schematically showing a holding process of the first epitaxial growth film in step ST109 in Fig. 11;
Fig. 16 is a cross-sectional view schematically showing an etching process of a sacrificial layer in the step ST109 in Fig. 11;
Figs. 17A and 17B are a top view and a cross-sectional view schematically showing the structure of a second epitaxial growth film in step ST105 in Fig. 11;
Figs. 18A and 18B are a top view and a cross-sectional view schematically showing the structure of the second epitaxial growth film in step ST106 in Fig. 11;
Fig. 19 is a cross-sectional view schematically showing a holding process of the second epitaxial growth film in step ST107 in Fig. 11;
Fig. 20 is a cross-sectional view schematically showing an etching process of a sacrificial layer in the step ST107 in Fig. 11;
Fig. 21 is a cross-sectional view schematically showing a sticking process of the first epitaxial growth film in step ST108 in Fig. 11;
Fig. 22 is a cross-sectional view schematically showing a sticking process of the second epitaxial growth film in step ST110 in Fig. 11;
Fig. 23 is a diagram showing a crystal c-axis of the monocrystalline PZT film as a first monocrystalline piezoelectric film and a crystal c-axis of the monocrystalline AlN film as a second monocrystalline piezoelectric film;
Fig. 24 is a diagram schematically showing the configuration of an acoustic oscillation sensor employing a semiconductor integrated device according to the first embodiment;
Fig. 25 is a diagram showing a principle of operation of the acoustic oscillation sensor;
Fig. 26 is a side view schematically showing the structure of a piezoelectric film integrated device according to a modification of the first embodiment;
Fig. 27 is a top view schematically showing the structure of the piezoelectric film integrated device in Fig. 26;
Fig. 28 is a cross-sectional view of the piezoelectric film integrated device in Fig. 27 taken along the line S28-S28;
Fig. 29 is a bottom view schematically showing the structure of the piezoelectric film integrated device in Fig. 26;
Fig. 30 is a side view schematically showing the structure of a piezoelectric film integrated device according to a second embodiment;
Fig. 31 is a top view schematically showing the structure of the piezoelectric film integrated device in Fig. 30;
Fig. 32 is a cross-sectional view of the piezoelectric film integrated device in Fig. 31 taken along the line S32-S32;
Fig. 33 is a flowchart showing a method of manufacturing the piezoelectric film integrated device in Fig. 30;
Fig. 34 is a cross-sectional view schematically showing the structure of a PZT epitaxial growth film in step ST202 in Fig. 33;
Fig. 35 is a cross-sectional view schematically showing the structure of the PZT epitaxial growth film (individual piece) in step ST203 in Fig. 33;
Fig. 36 is a cross-sectional view schematically showing the structure of the PZT epitaxial growth film (individual piece) and an AlN epitaxial growth film (individual piece) in step ST207 in Fig. 33;
Fig. 37 is a side view schematically showing the structure of a piezoelectric film integrated device according to a third embodiment;
Fig. 38 is a top view schematically showing the structure of the piezoelectric film integrated device in Fig. 37;
Fig. 39 is a cross-sectional view of the piezoelectric film integrated device in Fig. 38 taken along the line S39-S39;
Fig. 40 is a flowchart showing a method of manufacturing the piezoelectric film integrated device in Fig. 37;
Fig. 41 is a cross-sectional view schematically showing the structure of an AlN epitaxial growth film in step ST302 in Fig. 40;
Fig. 42 is a cross-sectional view schematically showing the structure of the AlN epitaxial growth film (individual piece) in step ST303 in Fig. 40;
Fig. 43 is a cross-sectional view schematically showing the structure of the AlN epitaxial growth film (individual piece) and a PZT epitaxial growth film (individual piece) in step ST307 in Fig. 40;
Fig. 44 is a cross-sectional view schematically showing the structure of an epitaxial growth film including the monocrystalline PZT film;
Fig. 45 is a cross-sectional view schematically showing the structure of an epitaxial growth film including the monocrystalline AlN film;
Fig. 46 is a cross-sectional view schematically showing the structure of a piezoelectric film integrated device according to a first modification of the first embodiment; and
Fig. 47 is a top view schematically showing the structure of the piezoelectric film integrated device in Fig. 46.

### DETAILED DESCRIPTION OF THE INVENTION

A piezoelectric film integrated device, a manufacturing method thereof, and an acoustic oscillation sensor according to each embodiment will be described below with reference to the drawings. The following embodiments are just examples and a variety of modifications are possible within the scope of the present disclosure. In the present application, the piezoelectric film integrated device is a device in which two or more monocrystalline piezoelectric films are provided on the same substrate. Further, in the present application, the acoustic oscillation sensor is a sensor that detects status (e.g., distance, shape, movement or the like) of a detection target object by outputting an acoustic oscillatory wave and detecting reflected waves of the acoustic oscillatory wave. The acoustic oscillation sensor is referred to also as an "ultrasonic sensor". In general, and in the present application, the acoustic oscillatory wave is made up of at least one of a sonic wave and an ultrasonic wave. Namely, the acoustic oscillatory wave includes a sonic wave, an ultrasonic wave, or both of a sonic wave and an ultrasonic wave.

### (1) First Embodiment

### (1-1) Structure of Piezoelectric Film Integrated Device 100

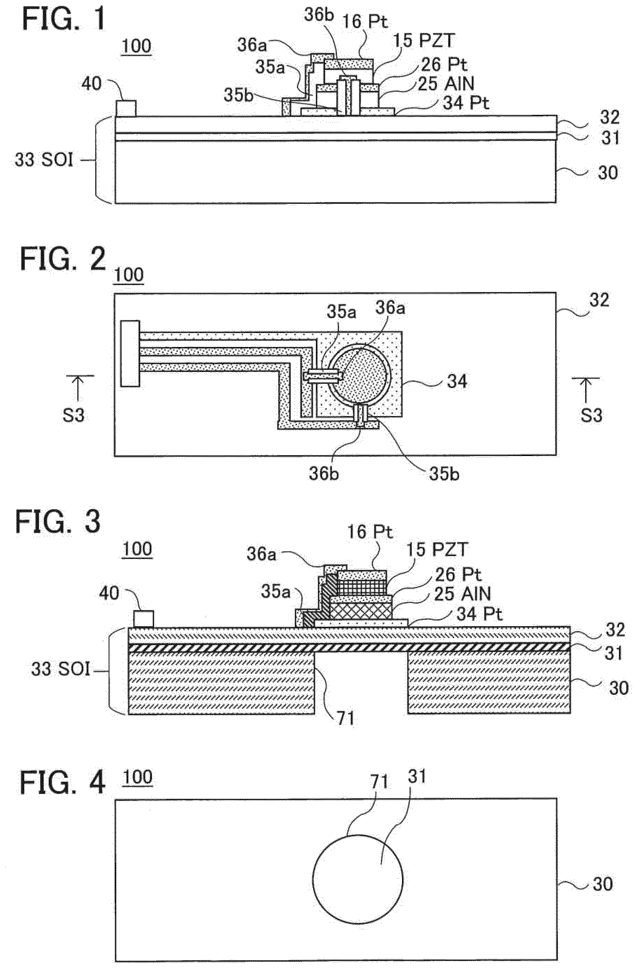

Fig. 1 is a side view schematically showing the structure of a piezoelectric film integrated device 100 according to a first embodiment. Fig. 2 is a top view schematically showing the structure of the piezoelectric film integrated device 100. Fig. 3 is a cross-sectional view of the piezoelectric film integrated device 100 in Fig. 2 taken along the line S3-S3. Fig. 4 is a bottom view schematically showing the structure of the piezoelectric film integrated device 100.

The piezoelectric film integrated device 100 includes an SOI substrate 33 as a substrate and a platinum (Pt) film 34 as an electrode provided on the SOI substrate 33. As shown in Fig. 2, the Pt film 34 is connected to a connector 40 via a wiring layer formed on the SOI substrate 33. The SOI stands for Silicon On Insulator. Further, in the SOI substrate 33, there may be formed a drive circuit for driving the piezoelectric film integrated device 100 and thereby generating the acoustic oscillatory wave, a processing circuit that executes a process by using an acoustic oscillatory wave detection signal, and so forth.

The piezoelectric film integrated device 100 includes a first piezoelectric element (25, 26) as a lower-side piezoelectric element provided on the Pt film 34 and a second piezoelectric element (15, 16) as an upper-side piezoelectric element provided on the first piezoelectric element. A Pt film 26 has a function as a common electrode for the first piezoelectric element (25, 26) and the second piezoelectric element (15, 16). However, the second piezoelectric element (15, 16) may have an electrode film other than the Pt film 26. The first piezoelectric element includes a monocrystalline AlN film 25 as a first monocrystalline piezoelectric film and the Pt film 26 as a first electrode film superimposed on the monocrystalline AlN film 25. The second piezoelectric element includes a monocrystalline PZT film 15 as a second monocrystalline piezoelectric film and a Pt film 16 as a second electrode film superimposed on the monocrystalline PZT film 15. The AlN represents aluminum nitride. The PZT represents piezoelectric zirconate titanate (lead zirconate titanate). As the first monocrystalline piezoelectric film, instead of the monocrystalline AlN film 25, a piezoelectric film made of a different monocrystalline material such as a monocrystalline lithium tantalate (monocrystalline LiTaO₃) film or a monocrystalline lithium niobate (monocrystalline LiNbO₃) film may be used. As the second monocrystalline piezoelectric film, instead of the monocrystalline PZT film 15, a piezoelectric film made of a different monocrystalline material such as a monocrystalline potassium sodium niobate (monocrystalline KNN) film or a monocrystalline barium titanate (monocrystalline BaTiO₃) film may be used. In the illustrated example, the first monocrystalline piezoelectric film is a piezoelectric body that detects the acoustic oscillatory wave (or its reflected waves), and is desired to be a piezoelectric body having lower specific inductive capacity and higher detection sensitivity compared to the second monocrystalline piezoelectric film. The second monocrystalline piezoelectric film is a piezoelectric body that generates the acoustic oscillatory wave, and is desired to be a piezoelectric body having a higher piezoelectric constant and capable of obtaining greater oscillation amplitude compared to the first monocrystalline piezoelectric film.

Incidentally, it is permissible even if the first piezoelectric element as the lower-side piezoelectric element includes a monocrystalline PZT film as the first monocrystalline piezoelectric film and a Pt film and the second piezoelectric element as the upper-side piezoelectric element includes a monocrystalline AlN film and a Pt film superimposed on the monocrystalline AlN film.

Further, the piezoelectric film integrated device 100 includes an insulation film 35a, a wiring film 36a formed on the insulation film 35a, an insulation film 35b, and a wiring film 36b formed on the insulation film 35b.

The SOI substrate 33 includes a Si substrate 30, a silicon dioxide (SiO₂) part 31 as an insulation film, and a monocrystalline silicon (monocrystalline Si) part 32. A cavity 71 is formed by etching the Si substrate 30 in a region of the monocrystalline silicon (monocrystalline Si) part 32 under the monocrystalline PZT film 15 and the monocrystalline AlN film 25 (i.e., a region overlapping with the piezoelectric films), and the SiO₂ part 31 and the monocrystalline silicon (monocrystalline Si) part 32 situated in the region where the cavity 71 is formed have a function as a vibrating plate. Further, variations in the thickness of the vibrating plate due to influence of the etching can be prevented by forming the silicon dioxide (SiO₂) part 31 made of a material different from the Si substrate 30 and giving the silicon dioxide (SiO₂) part 31 a function as an etching stop layer. Furthermore, as the substrate, a substrate made of a different material such as a glass substrate or an organic film substrate may also be used instead of the SOI substrate 33. In the Si substrate 30 of the SOI substrate 33, the cavity 71 that exposes the SiO₂ part 31 is formed. The cavity 71 is formed in a circular shape as an opening shape corresponding to the shape of the monocrystalline PZT film 15 or the monocrystalline AlN film 25. The acoustic oscillatory wave generated by the monocrystalline PZT film 15 is outputted through the cavity 71, and the monocrystalline AlN film 25 detects reflected waves of the acoustic oscillatory wave through the cavity 71.

The monocrystalline AlN film 25 of the first piezoelectric element is an epitaxial growth film having a (0001)-surface as a crystal face parallel to a surface of the Pt film 34 and being stuck (or bonded) on the surface of the Pt film 34. The monocrystalline PZT film 15 of the second piezoelectric element is an epitaxial growth film having a (001)-surface as a crystal face parallel to the surface of the Pt film 26 and being stuck (or bonded) on the surface of the Pt film 26 of the first piezoelectric element. The thickness of the monocrystalline PZT film 15 is generally in a range of 10 nm to 10 µm, and preferably in a range of 100 nm to 5 µm. The thickness of the monocrystalline AlN film 25 is generally in a range of 10 nm to 10 µm, and preferably in a range of 100 nm to 2 µm. The Pt film 34 is formed on an upper surface of the SOI substrate 33. The surface (upper surface) of the Pt film 34 and the (0001)-surface as the crystal face of the monocrystalline AlN film 25 are joined together by intermolecular force. The surface of the Pt film 26 of the first piezoelectric element and the (001)-surface as the crystal face of the monocrystalline PZT film 15 are joined together by intermolecular force. For these joints, the use of an adhesive agent is unnecessary. For excellently joining these surfaces by intermolecular force, the surface roughness of the Pt film 34 and the Pt film 26 is desired to be less than or equal to 10 nm. For this purpose, a process for smoothing the surfaces of the Pt film 34 and the Pt film 26 may be executed.

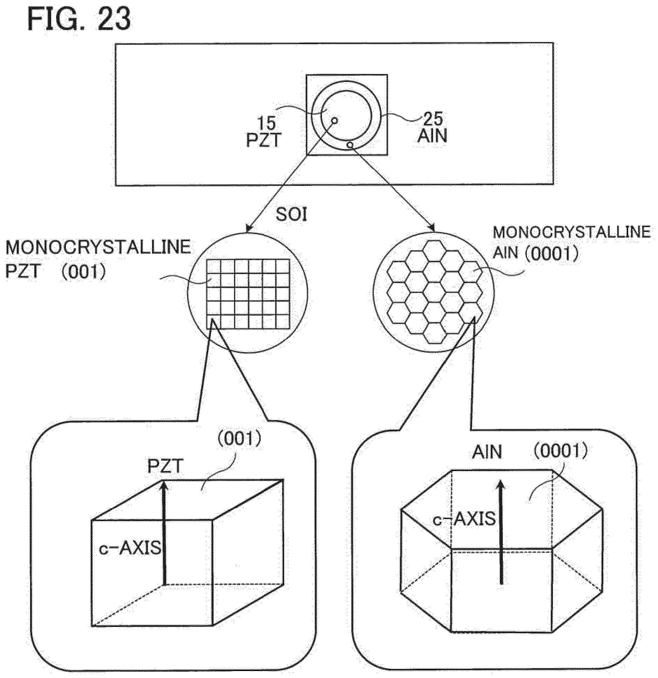

Further, a crystal c-axis direction of the monocrystalline PZT film 15 and a crystal c-axis direction of the monocrystalline AlN film 25 are in the parallel relationship. This feature will be described later by using Fig. 23.

### (1-2) Structure of Monocrystalline PZT Film

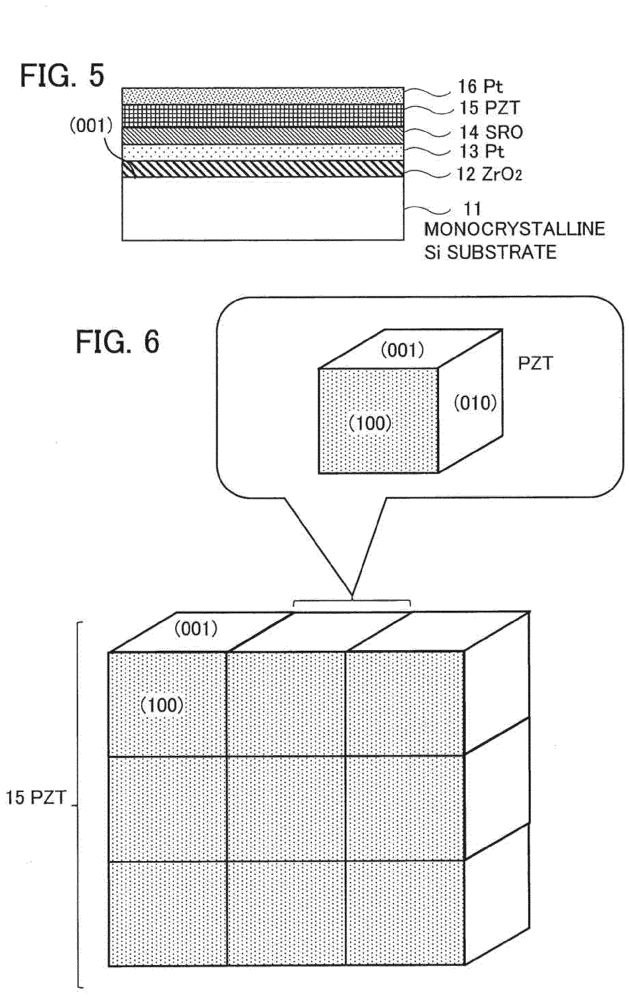

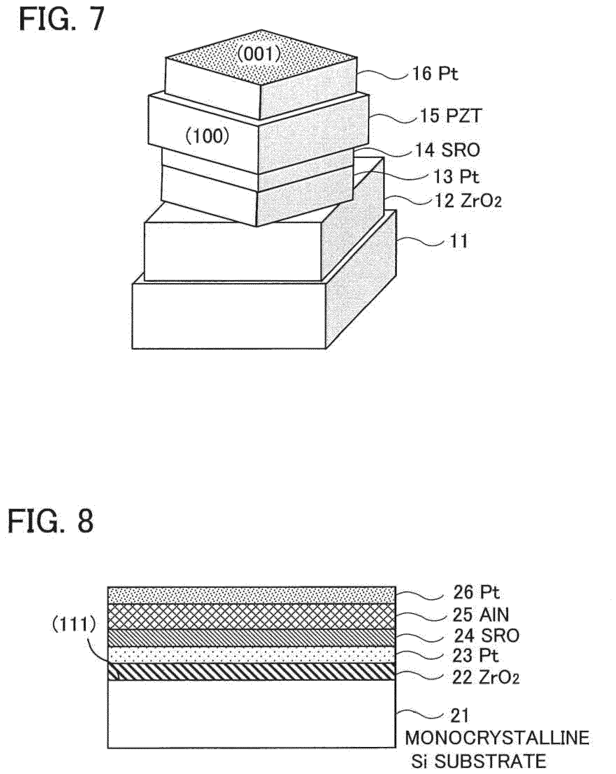

Fig. 5 is a cross-sectional view schematically showing the structure of the epitaxial growth film including the monocrystalline PZT film 15. Fig. 6 is a diagram showing the crystal structure of the monocrystalline PZT film 15 in Fig. 5. Fig. 7 is a diagram schematically showing the crystal structure of the epitaxial growth film in Fig. 5. Incidentally, in Fig. 7, the dimension in a vertical direction is reduced greatly compared to the dimension in a horizontal direction.

The epitaxial growth film in Fig. 5 is formed on a growth substrate 11 that is a monocrystalline Si substrate. The epitaxial growth film in Fig. 5 has a structure in which a monocrystalline zirconium dioxide (ZrO₂) film 12, a monocrystalline Pt film 13, a monocrystalline SRO film 14, a monocrystalline PZT film 15 and a monocrystalline Pt film 16 are stacked in this order. The growth substrate 11 is an example of a substrate whose upper surface is a (100)-surface. The ZrO₂ film 12 is an example of an orientation film having a cubic crystal structure and whose upper surface is a (100)-surface. The Pt film 13 is an example of a conductive film having a cubic crystal structure and whose upper surface is a (100)-surface. The SRO film 14 is a SrRuO₃ film (strontium ruthenate film) and is an example of an orientation film. The monocrystalline PZT film 15 is an example of a monocrystalline piezoelectric film for outputting oscillation. In cases where the monocrystalline PZT film 15 includes complex oxide having perovskite structure, the monocrystalline PZT film 15 can be grown epitaxially in the (001)-orientation in the cubic crystal representation on the growth substrate 11. On the monocrystalline PZT film 15, the Pt film 16 having a cubic crystal structure and being (100)-oriented is further grown epitaxially.

"The ZrO₂ film 12 is (100)-oriented" means that the (100)-surface of the ZrO₂ film 12 having a cubic crystal structure is formed along the (100)-surface of the growth substrate 11, namely, is parallel to the (100)-surface of the growth substrate 11. Further, "is parallel to" also means a state in which an angle formed by the upper surface of the growth substrate 11 and the (100)-surface of the ZrO₂ film 12 is less than or equal to 20°. Furthermore, the meaning of "orientation" is the same also for relationship between other films.

Table 1 shows the lattice constant of monocrystalline Si of the growth substrate 11, the lattice constant of ZrO₂ of the ZrO₂ film 12, the lattice constant of Pt of the Pt film 13, the lattice constant of SRO of the SRO film 14, and the lattice constant of monocrystalline PZT of the monocrystalline PZT film 15.

| TABLE 1 | |
|---|---|
| MATERIAL | LATTICE CONSTANT [nm] |
| MONOCRYSTALLINE PZT | 0.411 |
| SRO | 0.390 - 0.393 |
| Pt | 0.392 (0.544) |
| ZrO₂ | 0.511 |
| Si | 0.543 |

The lattice constant of Si is 0.543 nm, the lattice constant of ZrO₂ is 0.511 nm, and inconsistency of the lattice constant of ZrO₂ with the lattice constant of Si is as small as 6.1%, and thus the consistency of the lattice constant of ZrO₂ with the lattice constant of Si is high. Therefore, as shown in the schematic diagram of Fig. 7, the ZrO₂ film 12 as an orientation film can be grown epitaxially on a principal surface formed by the (100)-surface of the growth substrate 11. Accordingly, the ZrO₂ film 12 can be (100)-oriented in a cubic crystal structure on the (100)-surface of the growth substrate 11, and crystallinity of the ZrO₂ film 12 can be improved.

In cases where the ZrO₂ film 12 is a zirconium dioxide film having a cubic crystal structure and (100)-oriented, the ZrO₂ film 12 is oriented so that the ZrO₂ film 12's <100> direction along the upper surface of the growth substrate 11 as the principal surface is parallel to the <100> direction along the upper surface of the growth substrate 11.

Incidentally, "the ZrO₂ film 12's <100> direction along the upper surface of the growth substrate 11 is parallel to the <100> direction along the upper surface of the growth substrate 11" means not only that the ZrO₂ film 12's <100> direction is perfectly parallel to the <100> direction along the upper surface of the growth substrate 11 but also a state in which an angle formed by the ZrO₂ film 12's <100> direction and the <100> direction along the upper surface of the growth substrate 11 is less than or equal to 20°. The same goes not only for the ZrO₂ film 12 but also for in-plane orientation of a film in a different layer.

Meanwhile, although the lattice constant of ZrO₂ is 0.511 nm and the lattice constant of Pt is 0.392 nm as shown in Table 1, if Pt is rotated in a plane by 45°, the length of a diagonal line is 0.554 nm and the inconsistency of the length of the diagonal line with the lattice constant of ZrO₂ is as small as 8.1%. Thus, the Pt film 13 can be grown epitaxially on the (100)-surface of the ZrO₂ film 12.

Further, as shown in Table 1, the lattice constant of Pt is 0.392 nm, the lattice constant of SRO is 0.390 - 0.393 nm, and the inconsistency of the lattice constant of SRO with the lattice constant of Pt is as small as 0.5% or less. Thus, the consistency of the lattice constant of SRO with the lattice constant of Pt is high, and the SRO film 14 can be grown epitaxially on the (100)-surface of the Pt film 13 as shown in Fig. 7. Accordingly, the SRO film 14 can be (100)-oriented in the pseudo-cubic crystal representation on the (100)-surface of the Pt film 13, and the crystallinity of the SRO film 14 can be improved.

In cases where the monocrystalline PZT film 15 has a cubic crystal structure and includes a (100)-oriented PZT film, the piezoelectric zirconate titanate (lead zirconate titanate) film is oriented so that its <100> direction along the upper surface of the growth substrate 11 is parallel to the <100> direction along the upper surface of the growth substrate 11.

On the (001)-oriented monocrystalline PZT film 15, the Pt film 16 is grown epitaxially in the (100)-orientation and thereby formed as an electrode. The electrode film on the monocrystalline PZT film 15 is the uppermost layer, and thus may also be formed by a different manufacturing method.

### (1-3) Structure of Monocrystalline AlN Film

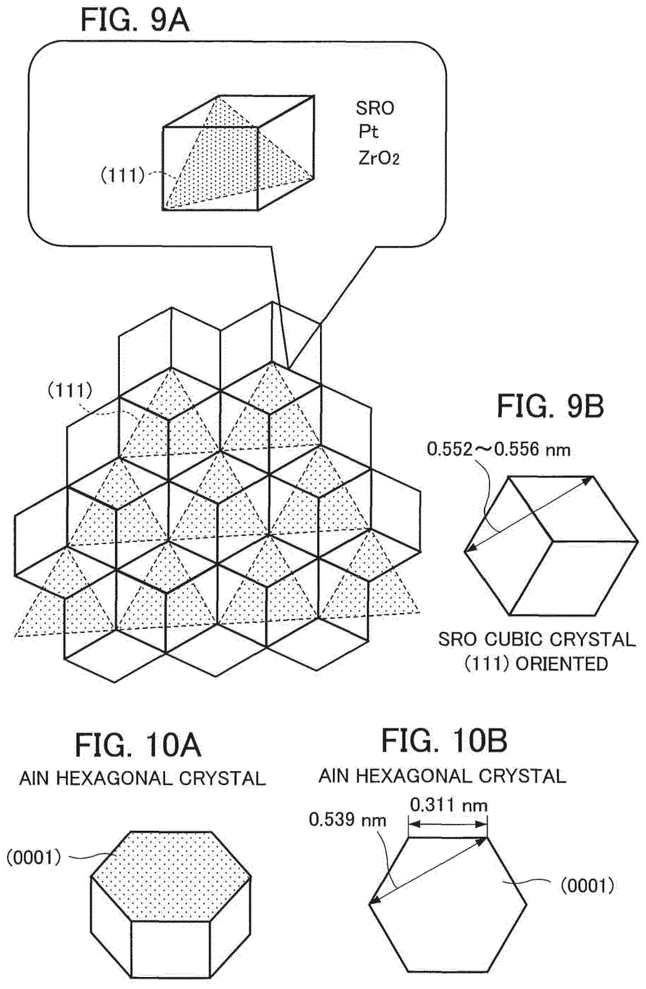

Fig. 8 is a cross-sectional view schematically showing the structure of the epitaxial growth film including the monocrystalline AlN film 25 as a monocrystalline piezoelectric film. Fig. 9A is a diagram schematically showing a (111)-surface of the crystal of each of the monocrystalline SRO film, the monocrystalline Pt film and the monocrystalline ZrO₂ film, and Fig. 9B is a diagram showing the lattice constant of the crystal of monocrystalline SRO. Fig. 10A is a diagram schematically showing the crystal structure of the monocrystalline AlN film 25, and Fig. 10B is a diagram showing the lattice constant of the crystal of the monocrystalline AlN film 25.

The epitaxial growth film in Fig. 8 is formed on a growth substrate 21 that is a monocrystalline Si substrate, for example. The epitaxial growth film has a structure in which a ZrO₂ film 22, a Pt film 23, an SRO film 24, a monocrystalline AlN film 25 and a Pt film 26 are stacked in this order. The growth substrate 21 is an example of a substrate whose upper surface is a (111)-surface. The ZrO₂ film 22 is an example of an orientation film having a cubic crystal structure and whose upper surface is a (111)-surface. The Pt film 23 is an example of a conductive film having a cubic crystal structure and whose upper surface is a (111)-surface. The SRO film 24 is a SrRuO₃ film. The monocrystalline AlN film 25 is an example of a monocrystalline piezoelectric film for detecting oscillation (i.e., for input). The Pt film 26 is an example of an upper electrode. In Fig. 9A, the shape of the (111)-surface of the SRO cubic crystal as bird's-eye viewed from above is shown. In Fig. 10A, the shape of the (0001)-surface as a crystal face of the AlN hexagonal crystal as bird's-eye viewed from above is shown.

In cases where the monocrystalline AlN film 25 is formed of a hexagonal crystal of aluminum nitride, the monocrystalline AlN film 25 can be grown epitaxially in the (0001)-orientation in the hexagonal crystal representation on the growth substrate 21. On the monocrystalline AlN film 25, the Pt film 26 having a cubic crystal structure and (100)-oriented can be further grown epitaxially.

"The ZrO₂ film 22 is (111)-oriented" means that the (111)-surface of the ZrO₂ film 22 having a cubic crystal structure is along the (111)-surface of the growth substrate 21, namely, is parallel to the (111)-surface of the growth substrate 21. Further, "parallel" also means a state in which an angle formed by the (111)-surface of the ZrO₂ film 22 and the principal surface of the growth substrate 21 is less than or equal to 20°. The same goes for orientation between other layers.

Table 2 shows the lattice constant of Si, the lattice constant of ZrO₂, the lattice constant of Pt, the lattice constant of SRO, and the lattice constant of monocrystalline AlN.

| TABLE 2 | |
|---|---|
| MATERIAL | LATTICE CONSTANT [nm] |
| MONOCRYSTALLINE AlN | 0.311 |
| SRO | 0.390 - 0.393 |
| Pt | 0.392 (0.544) |
| ZrO₂ | 0.511 |
| Si | 0.543 |

The lattice constant of Si is 0.543 nm, the lattice constant of ZrO₂ is 0.511 nm, and the inconsistency of the lattice constant of ZrO₂ with the lattice constant of Si is as small as 6.1%, and thus the consistency of the lattice constant of ZrO₂ with the lattice constant of Si is high. Thus, the ZrO₂ film 22 can be grown epitaxially on a principal surface formed by the (111)-surface of the growth substrate 21. Accordingly, the ZrO₂ film 22 can be (111)-oriented in a cubic crystal structure on the (111)-surface of the growth substrate 21, and the crystallinity of the ZrO₂ film 22 can be improved. The (111)-surface of the cubic crystal is shown in Fig. 9A.

In cases where the ZrO₂ film 22 as an orientation film is a zirconium dioxide film having a cubic crystal structure and (111)-oriented, the ZrO₂ film 22 is oriented so that the ZrO₂ film 22's <111> direction along the upper surface of the growth substrate 21 as the principal surface is parallel to the <111> direction along the upper surface of the growth substrate 21.

Incidentally, "the ZrO₂ film 22's <111> direction along the upper surface of the growth substrate 21 is parallel to the <111> direction along the upper surface of the growth substrate 21" means not only that the ZrO₂ film 22's <111> direction is perfectly parallel to the <111> direction along the upper surface of the growth substrate 21 but also a state in which an angle formed by the ZrO₂ film 22's <111> direction and the <111> direction along the upper surface of the growth substrate 21 is less than or equal to 20°. The same goes for orientation between films in different layers.

Meanwhile, although the lattice constant of ZrO₂ is 0.511 nm and the lattice constant of Pt is 0.392 nm, if Pt is rotated in a plane by 45°, the length of a diagonal line is 0.554 nm and the inconsistency of the length of the diagonal line with the lattice constant of ZrO₂ is as small as 8.1%, and thus the Pt film 23 can be grown epitaxially on the (111)-surface of the ZrO₂ film 22.

Further, the lattice constant of Pt is 0.392 nm, the lattice constant of SRO is 0.390 - 0.393 nm, and the consistency of the lattice constant of SRO with the lattice constant of Pt is high. Thus, the SRO film 24 can be grown epitaxially on the (111)-surface of the Pt film 23 as shown in Figs. 9A and 9B. Accordingly, the SRO film 24 can be (111)-oriented in the pseudo-cubic crystal representation on the (111)-surface of the Pt film 23, and the crystallinity of the SRO film 24 can be improved. The length of the diagonal line of the (111)-surface of the SRO film is 0.552 - 0.556 nm and the inconsistency with the width 0.539 nm of the AlN hexagonal crystal is as small as 2.8% as shown in Fig. 10B, and thus the monocrystalline AlN film 25 can be grown epitaxially in the (0001)-orientation on the (111)-surface of the SRO film 24.

In cases where the monocrystalline AlN film 25 has a hexagonal crystal structure and includes a (0001)-oriented aluminum nitride film, the monocrystalline AlN film 25 is oriented so that its <111> direction along the upper surface of the growth substrate 21 is parallel to the <111> direction of the upper surface of the growth substrate 21. The (0001)-surface of the hexagonal crystal is shown in Figs. 10A and 10B. On the (0001)-oriented monocrystalline AlN film 25, the Pt film 26 is further grown epitaxially in the (111)-orientation and thereby formed as an electrode. The electrode film on the monocrystalline AlN film 25 is the uppermost layer, and thus may also be formed by a different manufacturing method.

### (1-4) Manufacturing Method

A method for manufacturing the piezoelectric film integrated device 100 by using the PZT epitaxial growth film (including the monocrystalline PZT film 15 and the Pt film 16) as a piezoelectric element deposited on the growth substrate 11 of monocrystalline Si whose upper surface is a (100)-surface and the AlN epitaxial growth film (including the monocrystalline AlN film 25 and the Pt film 26) as a piezoelectric element deposited on the growth substrate 21 of monocrystalline Si whose upper surface is a (111)-surface will be described below.

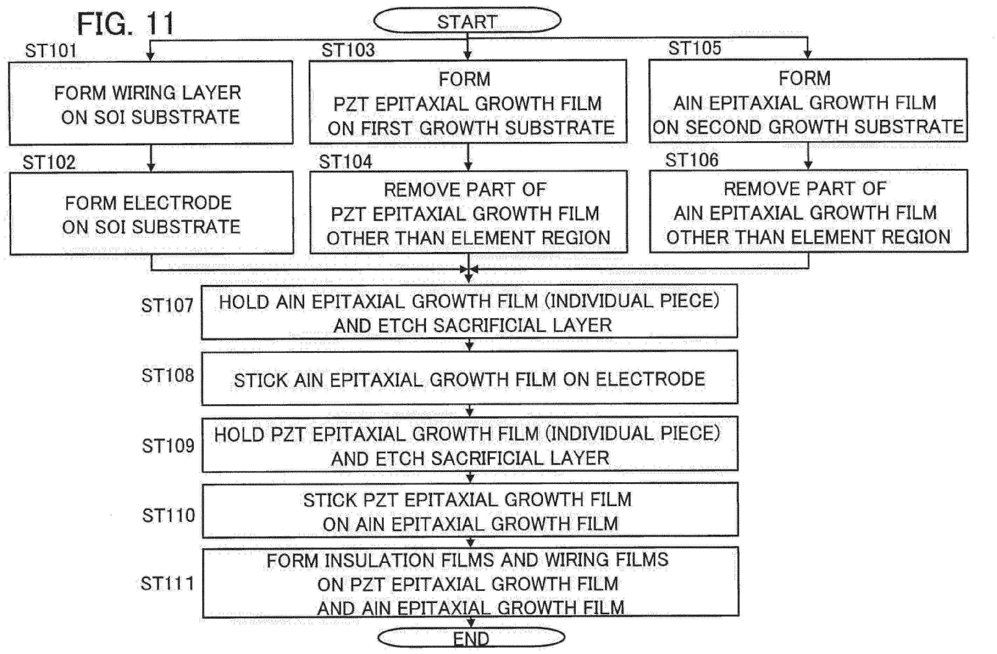

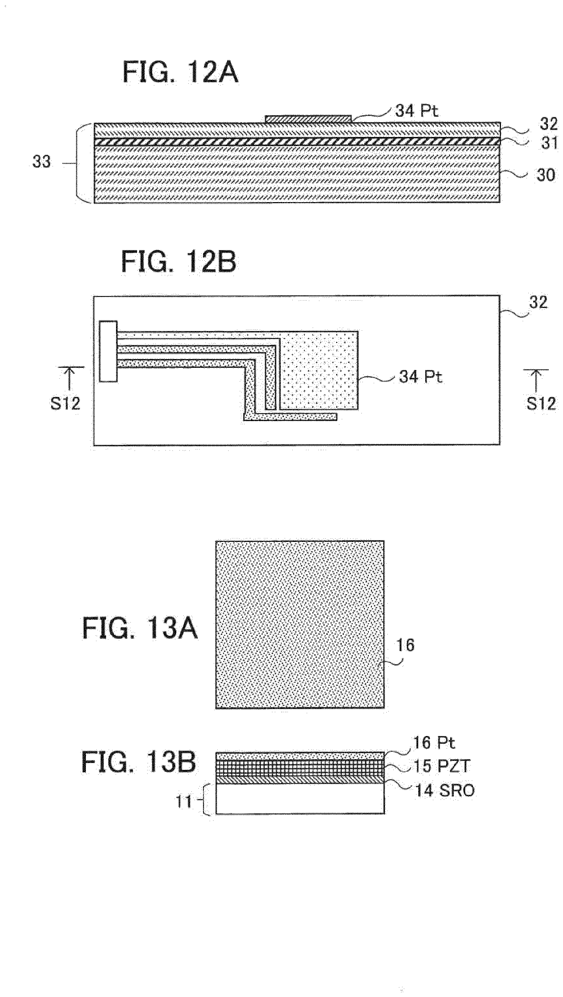

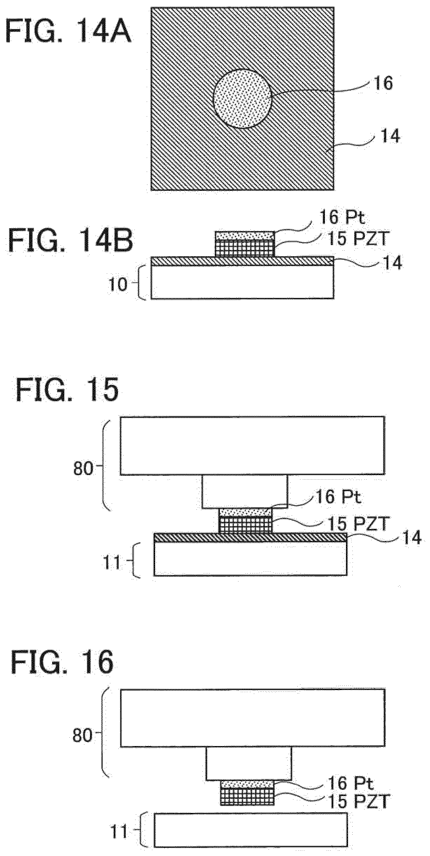

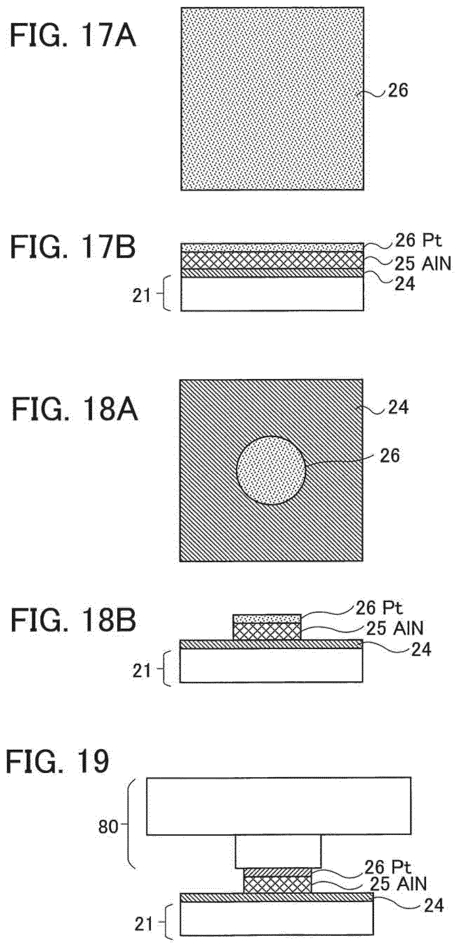

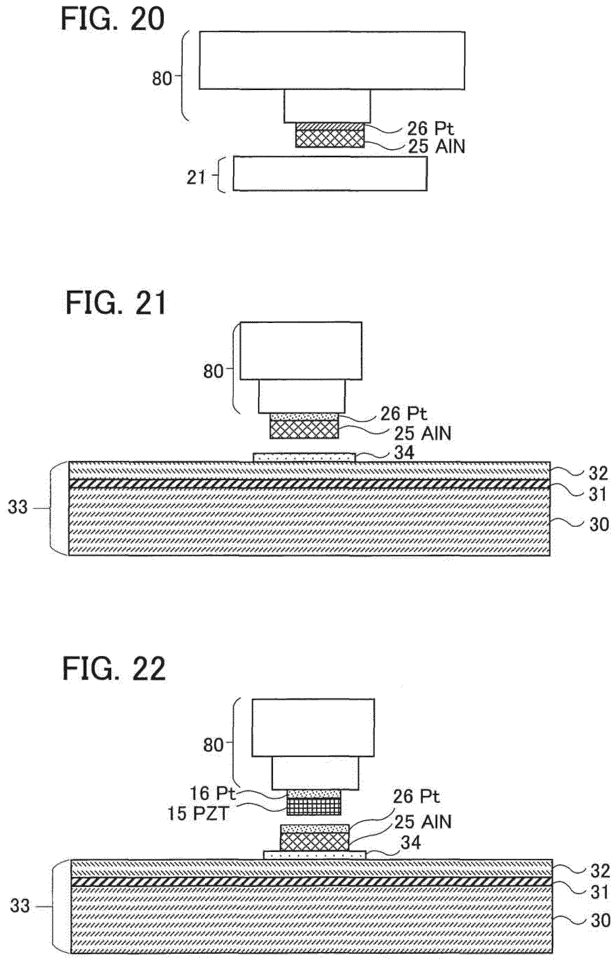

Fig. 11 is a flowchart showing a method of manufacturing the piezoelectric film integrated device 100. Figs. 12A and 12B show step ST102 in Fig. 11. Figs. 13A and 13B show step ST103 in Fig. 11, and Figs. 14A and 14B show step ST104 in Fig. 11. Fig. 15 and Fig. 16 show step ST109 in Fig. 11. Figs. 17A and 17B show step ST105 in Fig. 11, and Figs. 18A and 18B show step ST106 in Fig. 11. Fig. 19 and Fig. 20 show step ST107 in Fig. 11. Fig. 21 shows step ST108 in Fig. 11, and Fig. 22 shows step ST110 in Fig. 11.

First, a wiring layer is formed on the SOI substrate 33 being a device substrate (step ST101). Subsequently, as shown in Figs. 12A and 12B, the Pt film 34 as the electrode is formed on the principal surface of the SOI substrate 33.

Further, the SRO film 14, the monocrystalline PZT film 15 and the Pt film 16 are grown epitaxially on the growth substrate 11 as a first growth substrate as shown in Figs. 13A and 13B (step ST103), and the monocrystalline PZT film 15 and the Pt film 16 are formed into a circular shape by means of etching as shown in Figs. 14A and 14B (step ST104).

Furthermore, the SRO film 24, the monocrystalline AlN film 25 and the Pt film 26 are grown epitaxially on the growth substrate 21 as a second growth substrate as shown in Figs. 17A and 17B (step ST105), and the monocrystalline AlN film 25 and the Pt film 26 are formed into a circular shape by means of etching (step ST106) as shown in Figs. 18A and 18B.

Subsequently, an individual piece (i.e., a piezoelectric element as the AlN epitaxial growth film) formed with the monocrystalline AlN film 25 and the Pt film 26 is held by a stamp 80 as a holding member as shown in Fig. 19, the individual piece is peeled off by etching the SRO film 24 as a sacrificial layer as shown in Fig. 20 and is moved onto the SOI substrate 33 (step ST107), and the individual piece (i.e., the piezoelectric element as the epitaxial growth film) formed with the monocrystalline AlN film 25 and the Pt film 26 is stuck (or bonded) on the Pt film 34 as shown in Fig. 21.

Subsequently, an individual piece (i.e., the second piezoelectric element in the first embodiment) formed with the monocrystalline PZT film 15 and the Pt film 16 is held by the stamp 80 as the holding member as shown in Fig. 15, and the individual piece is peeled off by etching the SRO film 14 as a sacrificial layer as shown in Fig. 16 and is moved onto the SOI substrate 33 being the device substrate as shown in Fig. 22 (step ST109).

Subsequently, as shown in Fig. 22, the individual piece (i.e., the piezoelectric element as the epitaxial growth film) formed with the monocrystalline PZT film 15 and the Pt film 16 is stuck (or bonded) on the Pt film 26 (step ST110). Subsequently, the insulation film 35a and the wiring film 36a are formed on the monocrystalline PZT film 15 and the Pt film 16, and the insulation film 35b and the wiring film 36b are formed on the monocrystalline AlN film 25 and the Pt film 26.

Fig. 23 is a diagram showing crystal c-axes of the monocrystalline PZT film 15 as the first monocrystalline piezoelectric film and the monocrystalline AlN film 25 as the second monocrystalline piezoelectric film. As shown in Fig. 23, at the time of the sticking, the hexagonal crystal of AlN and the cubic crystal of PZT are arranged in a phase relationship so that their c-axes are parallel to each other as illustrated, by which efficiency of the piezoelectric oscillation driving of the monocrystalline PZT film 15 and the piezoelectric oscillation reception of the monocrystalline AlN film 25 is maximized.

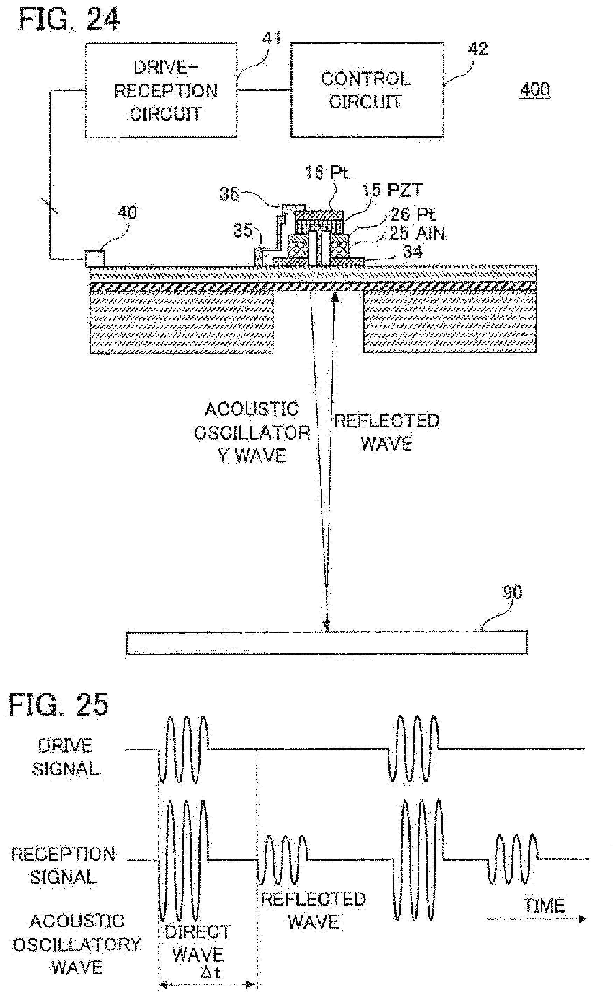

As shown in Fig. 24, the SOI substrate 33 is etched up to the SiO₂ part 31, thereby thinning down a back side of the piezoelectric element and forming the vibrating plate. The thickness of the vibrating plate can be set at a desired thickness by controlling the thickness of each layer of the SOI substrate 33.

### (1-5) Acoustic Oscillation Sensor

Fig. 24 schematically shows the configuration of the acoustic oscillation sensor 400 employing a semiconductor integrated device according to the first embodiment. Fig. 25 shows a principle of operation of the acoustic oscillation sensor. Upper and lower electrodes of the monocrystalline PZT film 15 are connected to a drive-reception circuit 41 and an AC bias at a frequency in the audible range or a frequency higher than the audible range is applied to the electrodes of the monocrystalline PZT film 15, by which the monocrystalline PZT film 15 oscillates in its thickness direction and the SiO₂ part 31 also oscillates in a similar manner. Due to the oscillation, the acoustic oscillatory wave is radiated and reflected waves bounced off a detection target object 90 oscillate the vibrating plate of the SOI substrate 33 having the monocrystalline AlN film 25 stuck thereon. Electric charge excited in the monocrystalline AlN film 25 due to the oscillation is amplified by the drive-reception circuit 41, and a control circuit 42 computes a distance to the detection target object 90 based on a time difference Δt regarding the reception of the reflected waves. The control circuit 42 and the drive-reception circuit 41 are formed by an electric circuit or an information processing device.

### (1-6) Modification

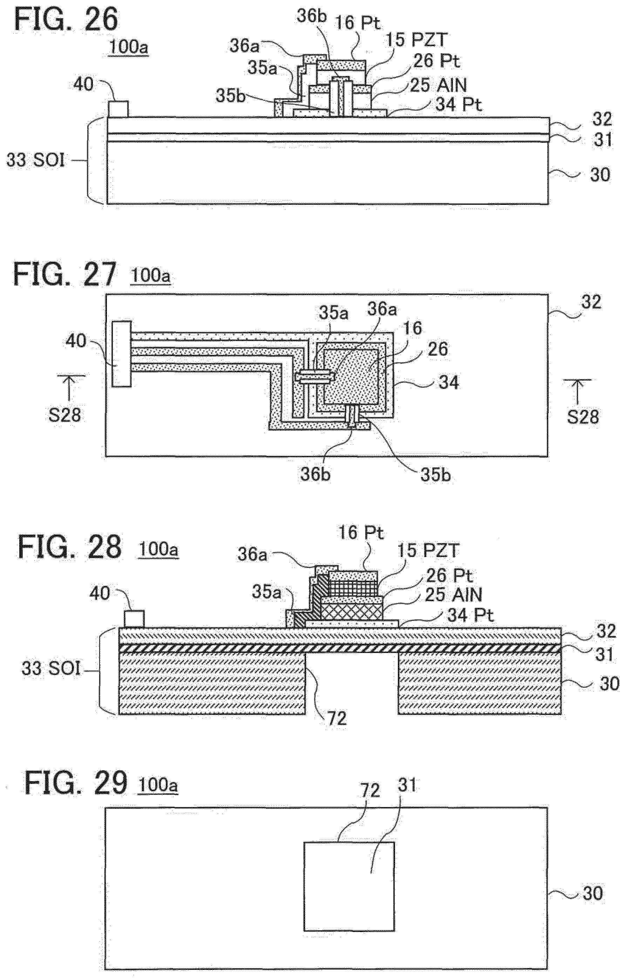

Fig. 26 is a side view schematically showing the structure of a piezoelectric film integrated device 100a according to a modification of the first embodiment. Fig. 27 is a top view schematically showing the structure of the piezoelectric film integrated device 100a. Fig. 28 is a cross-sectional view of the piezoelectric film integrated device 100a in Fig. 27 taken along the line S28-S28. Fig. 29 is a bottom view schematically showing the structure of the piezoelectric film integrated device 100a. When the SOI substrate 33 is etched up to the SiO₂ part 31, a cavity 72 may also be formed into a shape other than the circular shape, such as a quadrangular shape. The shape of the cavity 72 is desired to be a shape corresponding to a two-dimensional shape of the piezoelectric element.

### (1-7) Effect

As described above, the monocrystalline PZT film 15 and the monocrystalline AlN film 25, which are unlikely to grow epitaxially on the same SOI substrate 33 because of the difference in the lattice constant and the crystal structure, are respectively grown in monocrystalline epitaxial growth on separate growth substrates, peeled off from the growth substrates, and stuck (or bonded) on a common SOI substrate 33 in superimposition with each other, by which a high-performance piezoelectric film integrated device 100 can be manufactured.

Further, since the monocrystalline PZT film 15 has a higher piezoelectric constant compared to a polycrystalline PZT film, amplitude of the oscillation can be increased with ease.

Furthermore, since the monocrystalline AlN film 25 has lower specific inductive capacity compared to a polycrystalline AlN film, the oscillation reception sensitivity can be increased.

Moreover, conventionally, in order to form piezoelectric films of different types, a process like temporarily covering one piezoelectric film with a protective layer, forming the other piezoelectric film, and thereafter removing the protective layer used to be a complicated process, and application of heat in processing in each step used to leave residual stress distortion in the piezoelectric films and cause deterioration in the efficiency of the sensor. In the manufacturing method in the first embodiment, the sticking of the epitaxial growth films as the piezoelectric elements is employed, and thus the piezoelectric film integrated device and the acoustic oscillation sensor can be formed in a state with no residual stress distortion.

### (2) Second Embodiment

### (2-1) Structure

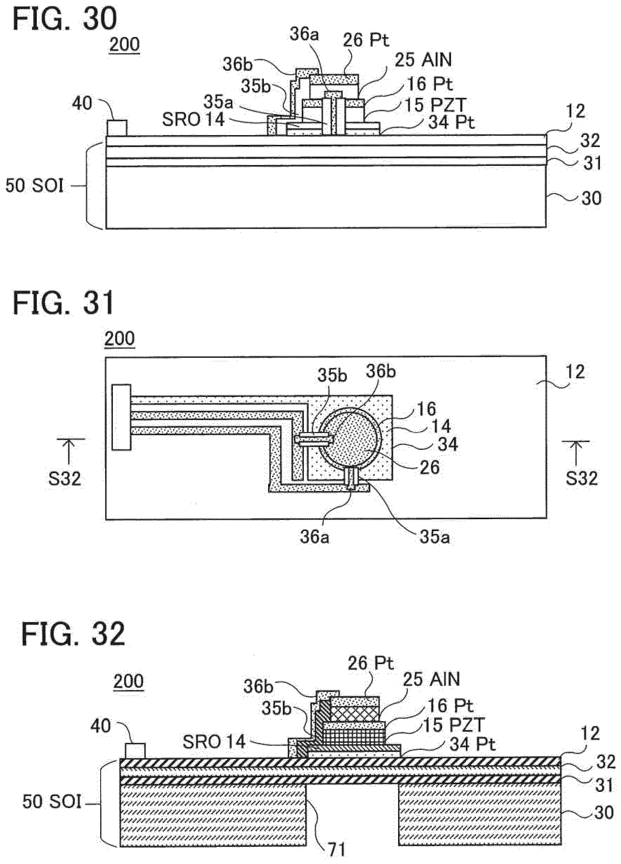

Fig. 30 is a side view schematically showing the structure of a piezoelectric film integrated device 200. Fig. 31 is a top view schematically showing the structure of the piezoelectric film integrated device 200. Fig. 32 is a cross-sectional view of the piezoelectric film integrated device 200 in Fig. 31 taken along the line S32-S32.

In the first embodiment, the AlN epitaxial growth film including the monocrystalline AlN film 25 and the Pt film 26 is grown on the growth substrate 21 and is stuck (or bonded) on the Pt film 34 on the SOI substrate 33, and the PZT epitaxial growth film including the monocrystalline PZT film 15 and the Pt film 16 is grown on the growth substrate 11 and is stuck (or bonded) on the AlN epitaxial growth film that has been stuck (or bonded) on the Pt film 34 on the SOI substrate 33. Alternatively, in the first embodiment, the AlN epitaxial growth film is stuck (or bonded) on the PZT epitaxial growth film that has been stuck (or bonded) on the Pt film 34 on the SOI substrate 33. In contrast, in a second embodiment, the PZT epitaxial growth film is grown on an SOI substrate 50. The upper surface of the SOI substrate 50 is formed by a (100) -surface. Therefore, the PZT epitaxial growth film can be grown epitaxially on the SOI substrate 50 by a process similar to the process in the first embodiment.

### (2-2) Manufacturing Method

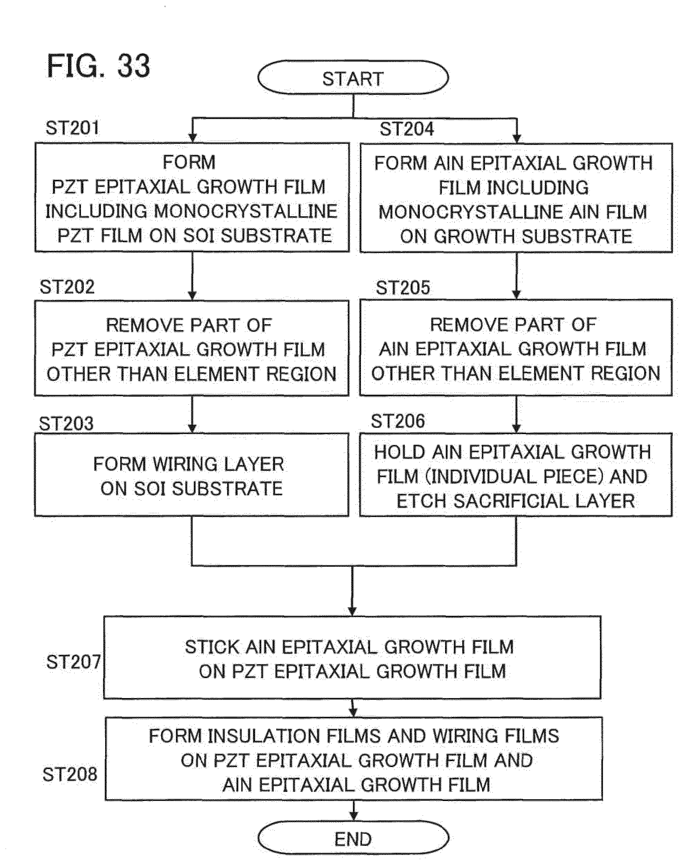

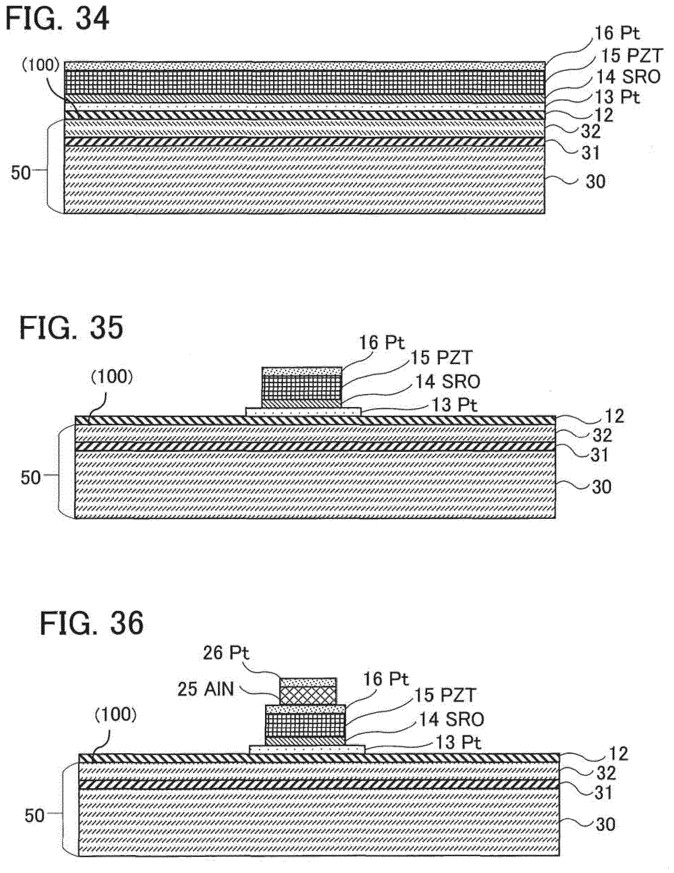

Fig. 33 is a flowchart showing a method of manufacturing the piezoelectric film integrated device 200. Fig. 34 shows step ST201 in Fig. 33, and Fig. 35 shows step ST202 in Fig. 33. Fig. 36 shows step ST207 in Fig. 33.

First, as shown in Fig. 34, the ZrO₂ film 12 and the Pt film 13 as an electrode layer are formed on the principal surface of the SOI substrate 50 being the device substrate (step ST201). Further, an epitaxial growth film made up of the SRO film 14, the monocrystalline PZT film 15 and the Pt film 16 is formed by epitaxially growing the SRO film 14, the monocrystalline PZT film 15 and the Pt film 16 on the Pt film 13 (step ST201). Subsequently, as shown in Fig. 35, the epitaxial growth film including the monocrystalline PZT film 15 is formed into a desired shape (e.g., circular shape) by means of etching (step ST202). Subsequently, the Pt film 34 as an electrode is formed by etching the Pt film 13 as the electrode layer, and a wiring layer is formed on the SOI substrate 50 (step ST203).

Subsequently, the individual piece of the AlN epitaxial growth film (upper-side piezoelectric element) made up of the monocrystalline AlN film 25 and the Pt film 26 is held by the stamp 80 as the holding member, and the individual piece of the AlN epitaxial growth film is peeled off by etching the SRO film 24 as the sacrificial layer and is moved onto and stuck (or bonded) on the PZT epitaxial growth film on the SOI substrate 50 being the device substrate as shown in Fig. 36 (steps ST204 to ST207). Namely, the piezoelectric element including the monocrystalline AlN film 25 and the Pt film 26 described in the first embodiment is stuck (or bonded) on the Pt film 16. At the time of the sticking, the crystal orientation of the monocrystalline PZT film 15 is checked by an inspection or the like, and the crystal orientation of the monocrystalline PZT film 15 and the crystal orientation of the monocrystalline AlN film 25 are aligned with each other as shown in Fig. 23. Since the orientation of the monocrystalline PZT film 15 is fixed on the SOI substrate 50, the angle of the sticking of the monocrystalline AlN film 25 is adjusted. It is also possible to check the crystal orientation at the time of the etching process shown in Fig. 35 and thereafter form the piezoelectric film to be in the same orientation as in the first embodiment by using a mask. As shown in Fig. 30, the insulation film 35a and the wiring film (lead wiring) 36a are formed on the monocrystalline PZT film 15 and the Pt film 16, and the insulation film 35b and the wiring film (lead wiring) 36b are formed on the monocrystalline AlN film 25 and the Pt film 26.

Thereafter, the manufacture of the piezoelectric film integrated device 200 shown in Fig. 30 to Fig. 32 is completed by etching the SOI substrate 50 similarly to the first embodiment.

### (2-3) Effect

In the second embodiment, the epitaxial growth film including the monocrystalline AlN film 25 is stuck on the Pt film 34 on the SOI substrate 50 having the epitaxially grown monocrystalline PZT film 15 thereon, by which a monocrystalline and high-performances piezoelectric film integrated device can be obtained similarly to the first embodiment.

In the second embodiment, alignment accuracy of the monocrystalline PZT film 15 increases compared to the first embodiment. Therefore, in the second embodiment, the acoustic oscillatory wave output performances increases compared to the first and third embodiments.

Except for the above-described features, the second embodiment is the same as the first embodiment.

### (3) Third Embodiment

### (3-1) Structure

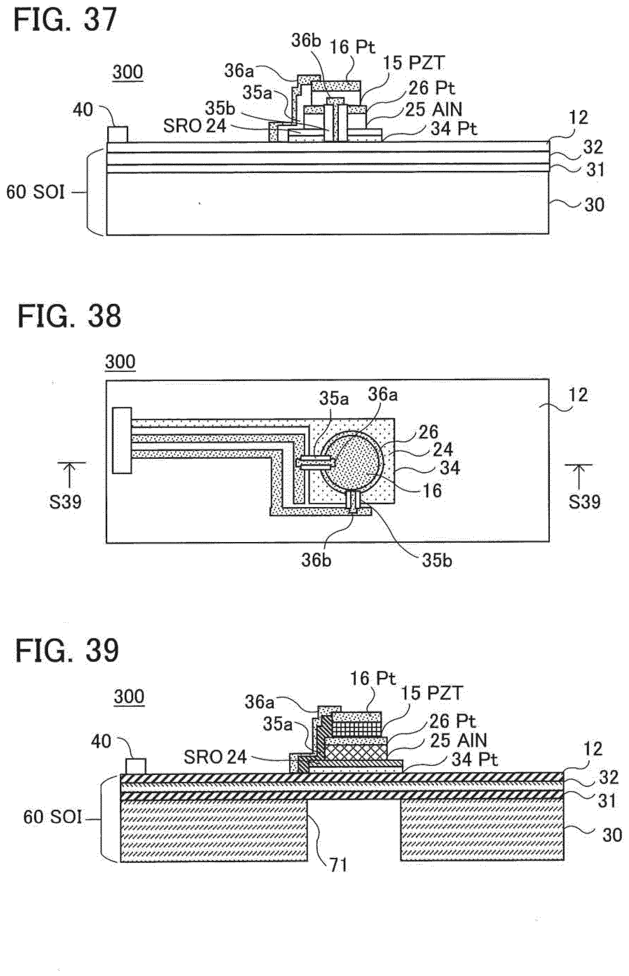

Fig. 37 is a side view schematically showing the structure of a piezoelectric film integrated device 300. Fig. 38 is a top view schematically showing the structure of the piezoelectric film integrated device 300. Fig. 39 is a cross-sectional view of the piezoelectric film integrated device in Fig. 38 taken along the line S39-S39.

In the first embodiment, the AlN epitaxial growth film is grown on the growth substrate 21, the PZT epitaxial growth film is grown on the growth substrate 11, and the PZT epitaxial growth film is stuck (or bonded) on the AlN epitaxial growth film that has been stuck (or bonded) on the Pt film 34 on the SOI substrate 33. Alternatively, in the first embodiment, the AlN epitaxial growth film is stuck (or bonded) on the PZT epitaxial growth film that has been stuck (or bonded) on the Pt film 34 on the SOI substrate 33. In contrast, in a third embodiment, the PZT epitaxial growth film is grown on an SOI substrate 60. The upper surface of the SOI substrate 60 is formed by a (111)-surface. Therefore, the AlN epitaxial growth film can be grown epitaxially on the SOI substrate 60 by a process similar to the process in the first embodiment.

### (3-2) Manufacturing Method

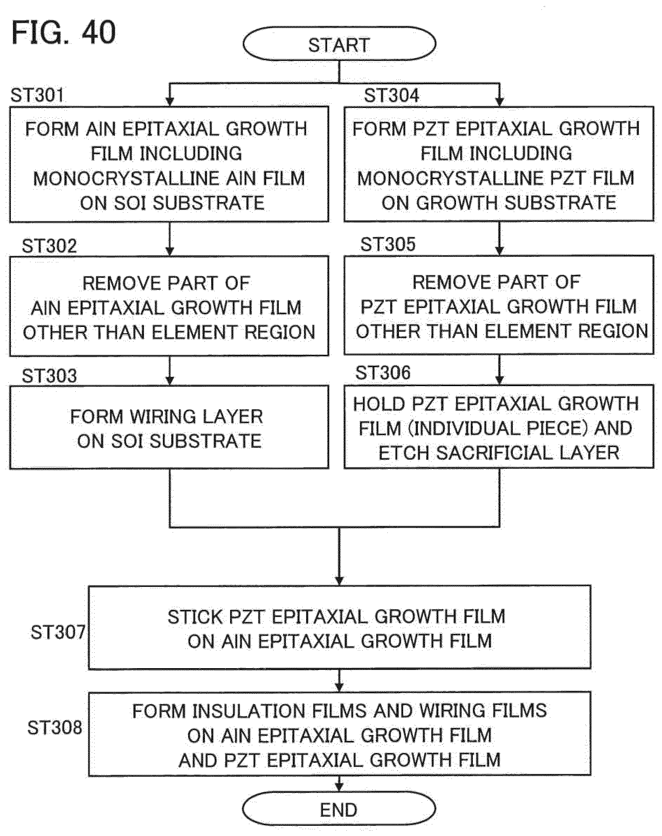

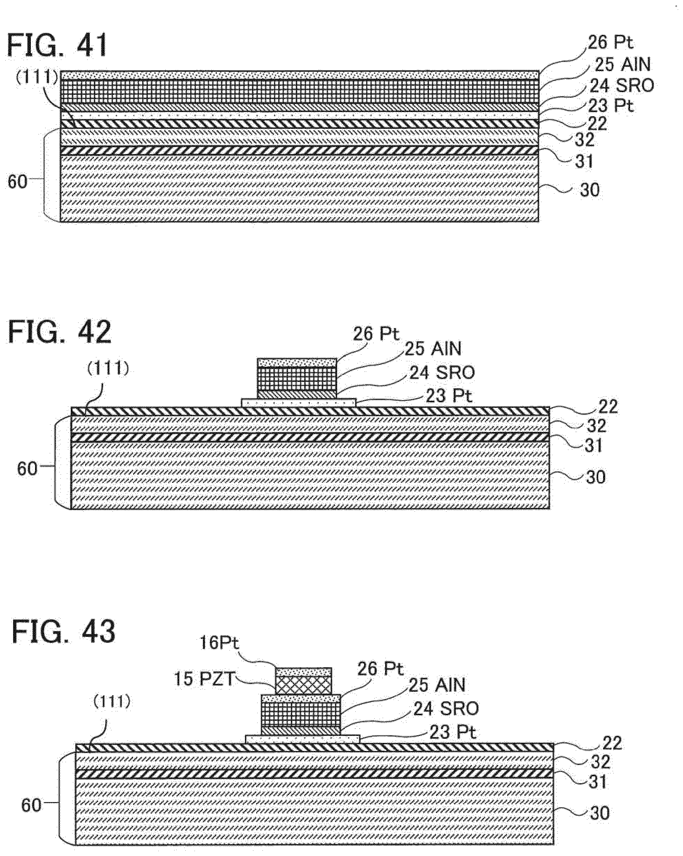

Fig. 40 is a flowchart showing a method of manufacturing the piezoelectric film integrated device 300. Fig. 41 shows step ST301 in Fig. 40, and Fig. 42 shows step ST302 in Fig. 40. Fig. 43 shows step ST307 in Fig. 40.

First, as shown in Fig. 41, the ZrO₂ film 22 and the Pt film 23 as an electrode layer are formed on the principal surface of the SOI substrate 60 being the device substrate. Further, an epitaxial growth film made up of the SRO film 24, the monocrystalline AlN film 25 and the Pt film 26 is formed by epitaxially growing the SRO film 24, the monocrystalline AlN film 25 and the Pt film 26 on the Pt film 23 (step ST301). Subsequently, as shown in Fig. 42, the epitaxial growth film including the monocrystalline AlN film 25 is formed into a desired shape (e.g., circular shape) by means of etching (step ST302). Subsequently, the Pt film 26 as the first electrode is formed by etching the Pt film 23 as the electrode layer, and a wiring layer is formed on the SOI substrate 60 (step ST303).

Subsequently, the individual piece of the PZT epitaxial growth film (upper-side piezoelectric element) made up of the monocrystalline PZT film 15 and the Pt film 16 is held by the stamp 80 as the holding member, and the individual piece of the PZT epitaxial growth film is peeled off by etching the SRO film 14 as the sacrificial layer and is moved onto and stuck (or bonded) on the AlN epitaxial growth film on the SOI substrate 60 being the device substrate as shown in Fig. 43 (steps ST304 to ST307). Namely, the piezoelectric element including the monocrystalline PZT film 15 and the Pt film 16 described in the first embodiment is stuck (or bonded) on the Pt film 26. At the time of the sticking, the crystal orientation of the monocrystalline PZT film 15 is checked by an inspection or the like, and the crystal orientation of the monocrystalline PZT film 15 and the crystal orientation of the monocrystalline AlN film 25 are aligned with each other as shown in Fig. 23. Since the orientation of the monocrystalline AlN film 25 is fixed on the SOI substrate 60, the angle of the sticking of the monocrystalline PZT film 15 is adjusted. It is also possible to check the crystal orientation at the time of the etching process shown in Fig. 42 and thereafter form the piezoelectric film to be in the same orientation as in the first embodiment by using a mask. As shown in Fig. 39, the insulation film 35a and the wiring film (lead wiring) 36a are formed on the monocrystalline PZT film 15 and the Pt film 16, and the insulation film 35b and the wiring film (lead wiring) 36b are formed on the monocrystalline AlN film 25 and the Pt film 26.

Thereafter, the manufacture of the piezoelectric film integrated device 300 shown in Fig. 37 to Fig. 39 is completed by etching the SOI substrate 60 similarly to the first embodiment.

### (3-3) Effect

In the third embodiment, the epitaxial growth film including the monocrystalline PZT film 15 is stuck (or bonded) on the AlN epitaxial growth film including the epitaxially grown monocrystalline AlN film 25 and the Pt film 26, by which a high-performances piezoelectric film integrated device 300 can be obtained by use of a plurality of monocrystalline piezoelectric films similarly to the first embodiment.

In the third embodiment, the alignment accuracy of the monocrystalline AlN film 25 increases compared to the first embodiment. Therefore, in the third embodiment, the acoustic oscillatory wave detection sensitivity and the S/N ratio increase compared to the first and second embodiments.

Except for the above-described features, the third embodiment is the same as the first or second embodiment.

### (4) First Modification

A piezoelectric film integrated device 500 according to a first modification differs from the piezoelectric film integrated device 100 according to the first embodiment in which the epitaxial growth film stuck (or bonded) on the Pt film 34 is formed with the monocrystalline AlN film 25 and the Pt film 26 and the epitaxial growth film stuck (or bonded) on the Pt film 26 is formed with the monocrystalline PZT film 15 and the Pt film 16, in that the epitaxial growth film stuck (or bonded) on the Pt film 34 on the SOI substrate 33 is formed with a Pt film 126, the monocrystalline AlN film 25 and the Pt film 26 and the epitaxial growth film stuck (or bonded) on the Pt film 26 is formed with a Pt film 116, the monocrystalline PZT film 15 and the Pt film 16. Except for these features, the piezoelectric film integrated device 500 according to the first modification is the same as the piezoelectric film integrated device 100 according to the first embodiment.

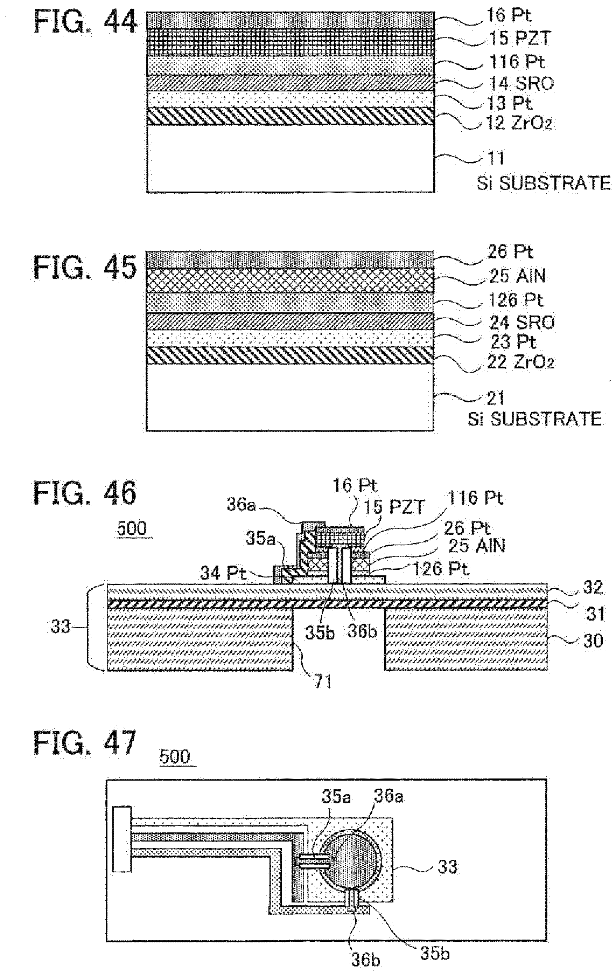

Fig. 44 is a cross-sectional view showing a state in which the Pt film 13, the SRO film 14, the Pt film 116, the monocrystalline PZT film 15 and the Pt film 16 have successively been grown epitaxially on the ZrO₂ film 12 on the Si substrate 11. Fig. 45 is a cross-sectional view showing a state in which the Pt film 23, the SRO film 24, the Pt film 126, the monocrystalline AlN film 25 and the Pt film 26 have successively been grown epitaxially on the ZrO₂ film 22 on the Si substrate 21.

Fig. 46 is a cross-sectional view schematically showing the structure of the piezoelectric film integrated device 500 according to the first modification. Fig. 47 is a top view schematically showing the structure of the piezoelectric film integrated device 500 in Fig. 46. In Fig. 46 and Fig. 47, each component identical or corresponding to a component shown in Fig. 1 to Fig. 4 (first embodiment) is assigned the same reference character as in Fig. 1 to Fig. 4. In the piezoelectric film integrated device 500 according to the first modification, the epitaxial growth film formed with the Pt film 126, the monocrystalline AlN film 25 and the Pt film 26 (shown in Fig. 45) is stuck (or bonded) on the Pt film 34, and the epitaxial growth film formed with the Pt film 116, the monocrystalline PZT film 15 and the Pt film 16 (shown in Fig. 44) is stuck (or bonded) on the Pt film 26. Except for these features, the piezoelectric film integrated device 500 according to the first modification is the same as the piezoelectric film integrated device 100 according to the first embodiment.

Incidentally, it is also possible to use the epitaxial growth film formed with the Pt film 116, the monocrystalline PZT film 15 and the Pt film 16 (shown in Fig. 44) instead of the epitaxial growth film formed with the monocrystalline PZT film 15 and the Pt film 16 in the piezoelectric film integrated device 200 or 300 according to the second or third embodiment (shown in Fig. 30 to Fig. 32 or Fig. 37 to Fig. 39). Further, it is also possible to use the epitaxial growth film formed with the Pt film 126, the monocrystalline AlN film 25 and the Pt film 26 (shown in Fig. 45) instead of the epitaxial growth film formed with the monocrystalline AlN film 25 and the Pt film 26 in the piezoelectric film integrated device 200 or 300 according to the second or third embodiment (shown in Fig. 30 to Fig. 32 or Fig. 37 to Fig. 39).

### (5) Second Modification

The piezoelectric film integrated devices 100, 200 and 300 and the acoustic oscillation sensors 400 according to the embodiments are usable not only for a distance sensor but also for other types of sensors such as a fingerprint sensor and a vein (pulse wave) sensor.

Further, with a piezoelectric film integrated device in which pairs of the monocrystalline PZT film 15 and the monocrystalline AlN film 25 are arranged in a matrix, a surface shape of the detection target object can be detected.

### (6) Description of Reference Characters

100, 100a, 200, 300, 500: piezoelectric film integrated device, 400: acoustic oscillation sensor, 11, 21: growth substrate (monocrystalline Si substrate), 15: monocrystalline PZT film (first monocrystalline piezoelectric film), 16: Pt film (electrode film), 14, 24: SRO film (orientation film), 25: monocrystalline AlN film (second monocrystalline piezoelectric film), 26: Pt film (electrode film), 31: SiO₂ part, 32: monocrystalline Si part, 33, 50, 60: SOI substrate (substrate), 34: Pt film (electrode), 71, 72: cavity, 116: Pt film, 126: Pt film.

## Claims

1. A piezoelectric film integrated device (100, 100a, 200, 300, 500) comprising:
a substrate (33, 50, 60);
an electrode (34) provided on the substrate (33, 50, 60);
a first piezoelectric element that is provided on the electrode (34) and includes a first monocrystalline piezoelectric film (25 or 15) and a first electrode film (26 or 16) superimposed on the first monocrystalline piezoelectric film (25 or 15); and
a second piezoelectric element that is provided on the first piezoelectric element and includes a second monocrystalline piezoelectric film (15 or 25) and a second electrode film (16 or 26) superimposed on the second monocrystalline piezoelectric film (15 or 25),
**characterised in that**
the second monocrystalline piezoelectric film (15 or 25) has a crystal structure different from a crystal structure of the first monocrystalline piezoelectric film (25 or 15).

2. The piezoelectric film integrated device (100, 100a, 200, 300, 500) according to claim 1, wherein the substrate (33, 50, 60) includes a vibrating plate provided in a region under the first monocrystalline piezoelectric film (25 or 15).

3. The piezoelectric film integrated device (100, 100a, 200, 300, 500) according to claim 2, wherein
the substrate (33, 50, 60) is an SOI substrate that includes a Si substrate (30), a SiO₂ part (31) and a monocrystalline Si part (32), and
the vibrating plate includes the SiO₂ part (31) and the monocrystalline Si part (32).

4. The piezoelectric film integrated device (200) according to any one of claims 1 to 3, wherein
the first monocrystalline piezoelectric film (25 or 15) is a monocrystalline PZT film (15), a monocrystalline KNN film or a monocrystalline barium titanate film, and
the second monocrystalline piezoelectric film (15 or 25) is a monocrystalline AlN film (25), a monocrystalline lithium tantalate film or a monocrystalline lithium niobate film.

5. The piezoelectric film integrated device (100, 100a, 300, 500) according to any one of claims 1 to 3, wherein
the first monocrystalline piezoelectric film (25 or 15) is a monocrystalline AlN film (25), a monocrystalline lithium tantalate film or a monocrystalline lithium niobate film, and
the second monocrystalline piezoelectric film (15 or 25) is a monocrystalline PZT film (15), a monocrystalline KNN film or a monocrystalline barium titanate film.

6. The piezoelectric film integrated device (200) according to any one of claims 1 to 3, wherein
the first monocrystalline piezoelectric film (15) has a (001)-surface as a crystal face parallel to a surface of the electrode (34), and
the first piezoelectric element is an epitaxial growth film stuck on the surface of the electrode (34).

7. The piezoelectric film integrated device (200) according to any one of claims 1 to 3, further comprising an SRO film (14) formed on the electrode (34), wherein
the first monocrystalline piezoelectric film (15) has a (001)-surface as a crystal face parallel to a surface of the SRO film (14), and
the first piezoelectric element is an epitaxial growth film formed on the surface of the SRO film (14).

8. The piezoelectric film integrated device (100, 100a) according to claim 6 or 7, wherein
the second monocrystalline piezoelectric film (25) has a (0001)-surface as a crystal face parallel to a surface of the electrode (34), and
the second piezoelectric element is an epitaxial growth film stuck on a surface of the first electrode film.

9. The piezoelectric film integrated device (100, 100a, 500) according to any one of claims 1 to 3, wherein
the first monocrystalline piezoelectric film (25) has a (0001)-surface as a crystal face parallel to a surface of the electrode (34), and
the first piezoelectric element is an epitaxial growth film stuck on the surface of the electrode (34).

10. The piezoelectric film integrated device (300) according to any one of claims 1 to 3, further comprising an SRO film formed on the electrode (34), wherein
the first monocrystalline piezoelectric film (25) has a (0001)-surface as a crystal face parallel to a surface of the SRO film (14), and
the first piezoelectric element is an epitaxial growth film formed on the surface of the SRO film (14).

11. The piezoelectric film integrated device (200) according to claim 9 or 10, wherein
the second monocrystalline piezoelectric film (15) has a (001)-surface as a crystal face parallel to a surface of the electrode (34), and
the second piezoelectric element is an epitaxial growth film stuck on a surface of the first electrode film.

12. The piezoelectric film integrated device (100, 100a, 200, 300, 500) according to any one of claims 1 to 11, wherein a crystal c-axis direction of the first monocrystalline piezoelectric film (25 or 15) and a crystal c-axis direction of the second monocrystalline piezoelectric film (15 or 25) are in a parallel relationship.

13. An acoustic oscillation sensor (400) comprising the piezoelectric film integrated device (100, 100a, 200, 300, 500) according to any one of claims 1 to 12, wherein
one of the first monocrystalline piezoelectric film (25 or 15) and the second monocrystalline piezoelectric film (15 or 25) outputs an acoustic oscillatory wave made up of at least one of a sonic wave and an ultrasonic wave, and
the other one of the first monocrystalline piezoelectric film (25 or 15) and the second monocrystalline piezoelectric film (15 or 25) detects reflected waves of the acoustic oscillatory wave.

14. A method of manufacturing a piezoelectric film integrated device (100, 100a), the method comprising:
growing a first epitaxial growth film, as a first piezoelectric element including a first monocrystalline piezoelectric film (25 or 15) and a first electrode film superimposed on the first monocrystalline piezoelectric film (25 or 15), on a first crystal face of a growth substrate (11);
growing a second epitaxial growth film, as a second piezoelectric element including a second monocrystalline piezoelectric film (15 or 25) having a crystal structure different from a crystal structure of the first monocrystalline piezoelectric film (25 or 15) and a second electrode film superimposed on the second monocrystalline piezoelectric film (15 or 25), on a second crystal face of another growth substrate (21); and
sticking the first epitaxial growth film peeled off from the growth substrate (11) on a substrate (33) having an electrode (34) and sticking the second epitaxial growth film peeled off from said another growth substrate (21) on the first epitaxial growth film.

15. A method of manufacturing a piezoelectric film integrated device (200, 300), the method comprising:
growing a first epitaxial growth film, as a first piezoelectric element including a first monocrystalline piezoelectric film (15 or 25) and a first electrode film superimposed on the first monocrystalline piezoelectric film (15 or 25), on a first crystal face of a substrate (50, 60) having an electrode (34);
growing a second epitaxial growth film, as a second piezoelectric element including a second monocrystalline piezoelectric film (25 or 15) and a second electrode film superimposed on the second monocrystalline piezoelectric film (25 or 15), on a second crystal face of a growth substrate (11, 21); and
sticking the second epitaxial growth film peeled off from the growth substrate (11, 21) on the first epitaxial growth film.

16. The method of manufacturing a piezoelectric film integrated device (100, 100a, 200, 300, 500) according to claim 14 or 15, wherein a crystal c-axis direction of the first monocrystalline piezoelectric film (25 or 15) and a crystal c-axis direction of the second monocrystalline piezoelectric film (15 or 25) are in a parallel relationship.

## Patentansprüche

1. Integrierte piezoelektrische Filmvorrichtung (100, 100a, 200, 300, 500), umfassend:
ein Substrat (33, 50, 60);
eine Elektrode (34), die auf dem Substrat (33, 50, 60) vorgesehen ist;
ein erstes piezoelektrisches Element, das auf der Elektrode (34) vorgesehen ist und einen ersten monokristallinen piezoelektrischen Film (25 oder 15) und einen ersten Elektrodenfilm (26 oder 16) enthält, die auf dem ersten monokristallinen piezoelektrischen Film (25 oder 15) überlagert sind; und
ein zweites piezoelektrisches Element, das auf dem ersten piezoelektrischen Element vorgesehen ist und einen zweiten monokristallinen piezoelektrischen Film (15 oder 25) und einen zweiten Elektrodenfilm (16 oder 26) enthält, die auf dem zweiten monokristallinen piezoelektrischen Film (15 oder 25) überlagert sind,
**dadurch gekennzeichnet, dass**
der zweite monokristalline piezoelektrische Film (15 oder 25) eine Kristallstruktur hat, die von einer Kristallstruktur des ersten monokristallinen piezoelektrischen Films (25 oder 15) verschieden ist.

2. Integrierte piezoelektrische Filmvorrichtung (100, 100a, 200, 300, 500) nach Anspruch 1, wobei das Substrat (33, 50, 60) eine Vibrationsplatte enthält, die in einer Region unter dem ersten monokristallinen piezoelektrischen Film (25 oder 15) vorgesehen ist.

3. Integrierte piezoelektrische Filmvorrichtung (100, 100a, 200, 300, 500) nach Anspruch 2, wobei
das Substrat (33, 50, 60) ein SOI-Substrat ist, das ein Si-Substrat (30), einen SiO₂-Teil (31) und einen monokristallinen Si-Teil (32) enthält, und
die Vibrationsplatte den SiO₂-Teil (31) und den monokristallinen Si-Teil (32) enthält.

4. Integrierte piezoelektrische Filmvorrichtung (200) nach einem der Ansprüche 1 bis 3, wobei
der erste monokristalline piezoelektrische Film (25 oder 15) ein monokristalliner PZT-Film (15), ein monokristalliner KNN-Film oder ein monokristalliner Bariumtitanatfilm ist, und
der zweite monokristalline piezoelektrische Film (15 oder 25) ein monokristalliner AIN-Film (25), ein monokristalliner Lithiumtantalatfilm oder ein monokristalliner Lithiumniobatfilm ist.

5. Integrierte piezoelektrische Filmvorrichtung (100, 100a, 300, 500) nach einem der Ansprüche 1 bis 3, wobei
der erste monokristalline piezoelektrische Film (25 oder 15) ein monokristalliner AIN-Film (25), ein monokristalliner Lithiumtantalat-Film oder ein monokristalliner Lithiumniobatfilm ist, und
der zweite monokristalline piezoelektrische Film (15 oder 25) ein monokristalliner PZT-Film (15), ein monokristalliner KNN-Film oder ein monokristalliner Bariumtitanatfilm ist.

6. Integrierte piezoelektrische Filmvorrichtung (200) nach einem der Ansprüche 1 bis 3, wobei
der erste monokristalline piezoelektrische Film (15) eine (001) - Oberfläche als eine Kristallfläche parallel zu einer Oberfläche der Elektrode (34) hat, und
das erste piezoelektrische Element ein epitaxial gewachsener Film ist, der auf der Oberfläche der Elektrode (34) angebracht ist.

7. Integrierte piezoelektrische Filmvorrichtung (200) nach einem der Ansprüche 1 bis 3, ferner umfassend einen SRO-Film (14), der auf der Elektrode (34) gebildet ist, wobei
der erste monokristalline piezoelektrische Film (15) eine (001) - Oberfläche als eine Kristallfläche parallel zu einer Oberfläche des SRO-Films (14) hat, und
das erste piezoelektrische Element ein epitaxial gewachsener Film ist, der auf der Oberfläche des SRO-Films (14) gebildet ist.

8. Integrierte piezoelektrische Filmvorrichtung (100, 100a) nach Anspruch 6 oder 7, wobei
der zweite monokristalline piezoelektrische Film (25) eine (0001) - Oberfläche als eine Kristallfläche parallel zu einer Oberfläche der Elektrode (34) hat, und
das zweite piezoelektrische Element ein epitaxial gewachsener Film ist, der auf einer Oberfläche des ersten Elektrodenfilms angebracht ist.

9. Integrierte piezoelektrische Filmvorrichtung (100, 100a, 500) nach einem der Ansprüche 1 bis 3, wobei
der erste monokristalline piezoelektrische Film (25) eine (0001) - Oberfläche als eine Kristallfläche parallel zu einer Oberfläche der Elektrode (34) hat, und
das erste piezoelektrische Element ein epitaxial gewachsener Film ist, der auf der Oberfläche der Elektrode (34) angebracht ist.

10. Integrierte piezoelektrische Filmvorrichtung (300) nach einem der Ansprüche 1 bis 3, ferner umfassend einen SRO-Film, der auf der Elektrode (34) gebildet ist, wobei
der erste monokristalline piezoelektrische Film (25) eine (0001) - Oberfläche als eine Kristallfläche parallel zu einer Oberfläche des SRO-Films (14) hat, und
das erste piezoelektrische Element ein epitaxial gewachsener Film ist, der auf der Oberfläche des SRO-Films (14) gebildet ist.

11. Integrierte piezoelektrische Filmvorrichtung (200) nach Anspruch 9 oder 10, wobei
der zweite monokristalline piezoelektrische Film (15) eine (001) - Oberfläche als eine Kristallfläche parallel zu einer Oberfläche der Elektrode (34) hat, und
das zweite piezoelektrische Element ein epitaxial gewachsener Film ist, der auf einer Oberfläche des ersten Elektrodenfilms angebracht ist.

12. Integrierte piezoelektrische Filmvorrichtung (100, 100a, 200, 300, 500) nach einem der Ansprüche 1 bis 11, wobei eine c-Achsen-Kristallrichtung des ersten monokristallinen piezoelektrischen Films (25 oder 15) und eine c-Achsen-Kristallrichtung des zweiten monokristallinen piezoelektrischen Films (15 oder 25) in einem parallelen Verhältnis sind.

13. Akustischer Oszillationssensor (400), umfassend die integrierte piezoelektrische Filmvorrichtung (100, 100a, 200, 300, 500) nach einem der Ansprüche 1 bis 12, wobei
einer von dem ersten monokristallinen piezoelektrischen Film (25 oder 15) und dem zweiten monokristallinen piezoelektrischen Film (15 oder 25) eine akustische Oszillationswelle ausgibt, die aus einer Schallwelle und/oder einer Ultraschallwelle gebildet ist, und
der andere von dem ersten monokristallinen piezoelektrischen Film (25 oder 15) und dem zweiten monokristallinen piezoelektrischen Film (15 oder 25) reflektierte Wellen der akustischen Oszillationswelle detektiert.

14. Verfahren zur Herstellung einer integrierten piezoelektrischen Filmvorrichtung (100, 100a), wobei das Verfahren umfasst:
Aufwachsen eines ersten epitaxial gewachsenen Films als ein erstes piezoelektrisches Element, das einen ersten monokristallinen piezoelektrischen Film (25 oder 15) und einen ersten Elektrodenfilm enthält, die auf dem ersten monokristallinen piezoelektrischen Film (25 oder 15) überlagert sind, auf einer ersten Kristallfläche eines Wachstumssubstrats (11);
Aufwachsen eines zweiten epitaxial gewachsenen Films als ein zweites piezoelektrisches Element, das einen zweiten monokristallinen piezoelektrischen Film (15 oder 25) mit einer Kristallstruktur, die von einer Kristallstruktur des ersten monokristallinen piezoelektrischen Films (25 oder 15) verschieden ist, und einen zweiten Elektrodenfilm enthält, die auf dem zweiten monokristallinen piezoelektrischen Film (15 oder 25) überlagert sind, auf einer zweiten Kristallfläche eines anderen Wachstumssubstrats (21); und
Anbringen des von dem Wachstumssubstrat (11) abgelösten ersten epitaxial gewachsenen Films auf einem Substrat (33) mit einer Elektrode (34), und Anbringen des von dem anderen Wachstumssubstrat (21) abgelösten zweiten epitaxial gewachsenen Films auf dem ersten epitaxial gewachsenen Film.

15. Verfahren zur Herstellung einer integrierten piezoelektrischen Filmvorrichtung (200, 300), wobei das Verfahren umfasst:
Aufwachsen eines ersten epitaxial gewachsenen Films als ein erstes piezoelektrisches Element, das einen ersten monokristallinen piezoelektrischen Film (25 oder 15) und einen ersten Elektrodenfilm enthält, die auf dem ersten monokristallinen piezoelektrischen Film (25 oder 15) überlagert sind, auf einer ersten Kristallfläche eines Substrats (50, 60), das eine Elektrode (34) hat;
Aufwachsen eines zweiten epitaxial gewachsenen Films als ein zweites piezoelektrisches Element, das einen zweiten monokristallinen piezoelektrischen Film (25 oder 15) und einen zweiten Elektrodenfilm enthält, die auf dem zweiten monokristallinen piezoelektrischen Film (25 oder 15) überlagert sind, auf einer zweiten Kristallfläche eines Wachstumssubstrats (11, 21); und
Anbringen des von dem Wachstumssubstrat (11, 21) abgelösten zweiten epitaxial gewachsenen Films auf dem ersten epitaxial gewachsenen Film.

16. Verfahren zur Herstellung einer integrierten piezoelektrischen Filmvorrichtung (100, 100a, 200, 300, 500) nach Anspruch 14 oder 15, wobei eine c-Achsen-Kristallrichtung des ersten monokristallinen piezoelektrischen Films (25 oder 15) und eine c-Achsen-Kristallrichtung des zweiten monokristallinen piezoelektrischen Films (15 oder 25) in einem parallelen Verhältnis sind.

## Revendications

1. Un dispositif (100, 100a, 200, 300, 500) à film piézoélectrique intégré comprenant :
un substrat (33, 50, 60) ;
une électrode (34) agencée sur le substrat (33, 50, 60) ;
un premier élément piézoélectrique qui est placé sur l'électrode (34) et qui comprend un premier film piézoélectrique monocristallin (25 ou 15) et un premier film électrode (26 ou 16) superposé sur le premier film piézoélectrique monocristallin (25 ou 15) ; et
un deuxième élément piézoélectrique qui est placé sur le premier élément piézoélectrique et qui comprend un deuxième film piézoélectrique monocristallin (15 ou 25) et un deuxième film électrode (16 ou 26) superposé sur le deuxième film piézoélectrique monocristallin (15 ou 25), **caractérisé en ce que**
le deuxième film piézoélectrique monocristallin (15 ou 25) a une structure cristalline différente d'une structure cristalline du premier film piézoélectrique monocristallin (25 ou 15).

2. Le dispositif (100, 100a, 200, 300, 500) à film piézoélectrique intégré selon la revendication 1, dans lequel le substrat (33, 50, 60) comprend une plaque vibrante placée dans une zone située sous le premier film piézoélectrique monocristallin (25 ou 15).

3. Le dispositif (100, 100a, 200, 300, 500) à film piézoélectrique intégré selon la revendication 2, dans lequel
le substrat (33, 50, 60) est un substrat SOI qui comprend un substrat Si (30), une partie SiO₂ (31) et une partie Si monocristalline (32), et
la plaque vibrante comprend la partie SiO₂ (31) et la partie Si monocristalline (32).

4. Le dispositif (200) à film piézoélectrique intégré selon l'une quelconque des revendications 1 à 3, dans lequel le premier film piézoélectrique monocristallin (25 ou 15) est un film PZT monocristallin (15), un film KNN monocristallin ou un film titanate de baryum monocristallin, et
le deuxième film piézoélectrique monocristallin (15 ou 25) est un film AIN monocristallin (25), un film tantalate de lithium monocristallin ou un film niobate de lithium monocristallin.

5. Le dispositif à film piézoélectrique intégré (100, 100a, 300, 500) selon l'une quelconque des revendications 1 à 3, dans lequel
le premier film piézoélectrique monocristallin (25 ou 15) est un film AIN monocristallin (25), un film tantalate de lithium monocristallin ou un film niobate de lithium monocristallin, et
le deuxième film piézoélectrique monocristallin (15 ou 25) est un film PZT monocristallin (15), un film KNN monocristallin ou un film titanate de baryum monocristallin.

6. Le dispositif (200) à film piézoélectrique intégré selon l'une quelconque des revendications 1 à 3, dans lequel
le premier film piézoélectrique monocristallin (15) a une surface (001) en tant que face cristalline parallèle à une surface de l'électrode (34), et
le premier élément piézoélectrique est un film de croissance épitaxial collé sur la surface de l'électrode (34).

7. Le dispositif (200) à film piézoélectrique intégré selon l'une quelconque des revendications 1 à 3, comprenant en outre un film SRO (14) formé sur l'électrode (34), dans lequel
le premier film piézoélectrique monocristallin (15) a une surface (001) en tant que face cristalline parallèle à une surface du film SRO (14), et
le premier élément piézoélectrique est un film de croissance épitaxiale formé sur la surface du film SRO (14).

8. Le dispositif (100, 100a) à film piézoélectrique intégré selon la revendication 6 ou la revendication 7, dans lequel
le deuxième film piézoélectrique monocristallin (25) présente une surface (0001) en tant que face cristalline parallèle à une surface de l'électrode (34), et
le deuxième élément piézoélectrique est un film de croissance épitaxial collé sur une surface du premier film électrode.

9. Le dispositif (100, 100a, 500) à film piézoélectrique intégré selon l'une quelconque des revendications 1 à 3, dans lequel
le premier film piézoélectrique monocristallin (25) présente une surface (0001) en tant que face cristalline parallèle à une surface de l'électrode (34), et
le premier élément piézoélectrique est un film de croissance épitaxial collé sur la surface de l'électrode (34).

10. Le dispositif (300) à film piézoélectrique intégré selon l'une quelconque des revendications 1 à 3, comprenant en outre un film SRO formé sur l'électrode (34), dans lequel
le premier film piézoélectrique monocristallin (25) a une surface (0001) en tant que face cristalline parallèle à une surface du film SRO (14), et
le premier élément piézoélectrique est un film de croissance épitaxiale formé sur la surface du film SRO (14).

11. Le dispositif (200) à film piézoélectrique intégré selon la revendication 9 ou la revendication 10, dans lequel
le deuxième film piézoélectrique monocristallin (15) a une surface (001) en tant que face cristalline parallèle à une surface de l'électrode (34), et
le deuxième élément piézoélectrique est un film de croissance épitaxiale collé sur une surface du premier film électrode.

12. Le dispositif (100, 100a, 200, 300, 500) à film piézoélectrique intégré selon l'une quelconque des revendications 1 à 11, dans lequel une direction d'axe c de cristal du premier film piézoélectrique monocristallin (25 ou 15) et une direction d'axe c de cristal du deuxième film piézoélectrique monocristallin (15 ou 25) sont dans une relation parallèle.

13. Un capteur d'oscillation acoustique (400) comprenant le dispositif (100, 100a, 200, 300, 500) à film piézoélectrique intégré selon l'une quelconque des revendications 1 à 12, dans lequel
l'un parmi le premier film piézoélectrique monocristallin (25 ou 15) et le deuxième film piézoélectrique monocristallin (15 ou 25) émet une onde oscillatoire acoustique composée d'au moins une parmi une onde sonore et une onde ultrasonore, et
l'autre parmi le premier film piézoélectrique monocristallin (25 ou 15) et le deuxième film piézoélectrique monocristallin (15 ou 25) détecte les ondes réfléchies de l'onde oscillatoire acoustique.

14. Un procédé de fabrication d'un dispositif (100, 100a) à film piézoélectrique intégré, le procédé comprenant :
le fait de faire croître un premier film de croissance épitaxiale, en tant que premier élément piézoélectrique comprenant un premier film piézoélectrique monocristallin (25 ou 15) et un premier film électrode superposé au premier film piézoélectrique monocristallin (25 ou 15), sur une première face cristalline d'un substrat de croissance (11) ;
le fait de faire croître un deuxième film de croissance épitaxiale, en tant que deuxième élément piézoélectrique comprenant un deuxième film piézoélectrique monocristallin (15 ou 25) ayant une structure cristalline différente d'une structure cristalline du premier film piézoélectrique monocristallin (25 ou 15) et un deuxième film électrode superposé au deuxième film piézoélectrique monocristallin (15 ou 25), sur une deuxième face cristalline d'un autre substrat de croissance 21 ; et
le fait de coller le premier film de croissance épitaxiale décollé du substrat de croissance (11) sur un substrat (33) ayant une électrode (34), et de coller le deuxième film de croissance épitaxiale décollé dudit autre substrat de croissance (21) sur le premier film de croissance épitaxiale.

15. Un procédé de fabrication d'un dispositif à film piézoélectrique intégré (200, 300), le procédé comprenant :
le fait de faire croître un premier film de croissance épitaxiale, en tant que premier élément piézoélectrique comprenant un premier film piézoélectrique monocristallin (15 ou 25) et un premier film électrode superposé au premier film piézoélectrique monocristallin (15 ou 25), sur une première face cristalline d'un substrat (50, 60) ayant une électrode (34) ;
le fait de faire croître un deuxième film de croissance épitaxiale, en tant que deuxième élément piézoélectrique comprenant un deuxième film piézoélectrique monocristallin (25 ou 15) et un deuxième film électrode superposé au deuxième film piézoélectrique monocristallin (25 ou 15), sur une deuxième face cristalline d'un substrat de croissance (11, 21) ; et
le fait de coller le deuxième film de croissance épitaxiale décollé du substrat de croissance (11, 21) sur le premier film de croissance épitaxiale.

16. Le procédé de fabrication d'un dispositif (100, 100a, 200, 300, 500) à film piézoélectrique intégré selon la revendication 14 ou la revendication 15, dans lequel une direction d'axe c de cristal du premier film piézoélectrique monocristallin (25 ou 15) et une direction d'axe c de cristal du deuxième film piézoélectrique monocristallin (15 ou 25) sont dans une relation parallèle.
